# EUROPÄISCHE PATENTSCHRIFT

(11) **EP 2 058 289 B1**
(45) Veröffentlichungstag und Bekanntmachung des Hinweises auf die Patenterteilung: **10.04.2013**
(21) Anmeldenummer: 07022794.7
(22) Anmeldetag: 23.11.2007
(51) Int. Cl.: C04B 35/587, B22D 41/02, C03C 17/22, C04B 41/50, C04B 41/87, C23C 20/08, C30B 11/00, C30B 15/10

(54) **Fest haftende siliciumnitridhaltige Trennschicht**
Strongly adhesive silicium nitride release layer
Couche antadhésive comprenant du nitrure de silicium à adhérence fixe

(30) Priorität: 08.11.2007 DE 102007053284
(43) Veröffentlichungstag der Anmeldung: 13.05.2009
(73) Patentinhaber: ESK Ceramics GmbH & Co.KG, 87437 Kempten (DE)
(72) Erfinder: Uibel, Krishna, Dr., 87435 Kempten (DE)
(74) Vertreter: Merkle, Gebhard

(56) Entgegenhaltungen:
- EP-A- 0 963 464
- EP-A- 1 985 594
- WO-A-03/078321
- WO-A-2007/039310
- DE-A1-102005 050 593
- DE-A1-102006 003 819
- JP-A- 2005 271 058
- JP-A- 2007 268 572

## Beschreibung

### Gebiet der Erfindung

Die vorliegende Erfindung betrifft eine siliciumnitridhaltige Schlichte zur Herstellung einer dauerhaften, fest haftenden Trennschicht auf einem Substrat, einen Formkörper aus einem Substrat und einer darauf aufgebrachten dauerhaften, fest haftenden Trennschicht, welche abrieb-, stoß- und kratzfest sowie temperaturstabil ist, so dass der Formkörper transportabel ist, ein Verfahren zur Herstellung eines solchen Formkörpers sowie die Verwendung solcher Formkörper auf dem Gebiet der korrosiven Nichteisenmetallschmelzen, insbesondere als Schmelztiegel zur Anwendung im Bereich der Solar-Silicium-Verarbeitung und andererseits die Verwendung eines solchen Formkörpers als Steigrohr in der Aluminium-Metallurgie, insbesondere dem Aluminium-Niederdruckguss.

### Hintergrund der Erfindung

Zum Erschmelzen und zur Rekristillation von Siliciumblöcken (Ingots) aus Siliciumkörnungen, Siliciumgranulaten oder Siliciumstückgut werden Tiegel aus Graphit oder aus Siliciumnitrid, jedoch hauptsächlich aus SiO₂ (fused silica) verwendet. Über exakt definierte Abkühlvorgänge kristallisieren aus der Schmelze Ingots mit den gewünschten Gefügen und Reinheiten aus, die anschließend zu dünnen Scheiben geschnitten werden und den aktiven Bestandteil von Photovoltaikanlagen bilden.

Wesentlich ist hierbei, dass durch die bei der Verarbeitung verwendeten Materialien, wie Schmelztiegel, die Solar-Silicium-Qualität nicht negativ beeinträchtigt wird und die Siliciumschmelze defektfrei erstarren und unzerstört aus dem Tiegel entformt werden kann. In diesem Zusammenhang ist es wichtig, den korrosiven Angriff von flüssigem Siliciummetall auf das Tiegelmaterial zu verhindern, da die Schmelze sonst verunreinigt würde. Ferner führen Anhaftungen, Infiltration und Diffusion zu Problemen beim Entformen der Ingots, sodass die Gefahr eines Reißens oder Zerspringens des polykristallinen Siliciumblocks besteht.

Durch die korrosive Siliciumschmelze kommt es zu einem Angriff auf den SiO₂ -Tiegel, da zwischen Si und SiO₂ eine chemische Reaktion unter Bildung von flüchtigem SiO stattfindet. Zudem gelangen auf diese Weise Sauerstoff und unerwünschte Verunreinigungen aus dem Tiegelmaterial in die Siliciumschmelze.

Insbesondere sind Anhaftungen des erstarrenden oder erstarrten Siliciumblocks unter allen Umständen zu vermeiden, da das Silicium sehr große thermische Ausdehnungen durchläuft, wobei kleinste Anhaftungen zu mechanischem Stress und damit zum Bruch der kristallinen Struktur führen, was einen Ausschuss an Siliciummaterial bedeutet.

In der Aluminium-Metallurgie, insbesondere beim Aluminium-Niederdruckguss werden Steigrohre aus Eisenlegierungen oder aus Quarzglas (fused silica) verwendet. Aufgrund der stark korrosiv wirkenden Aluminiumschmelze bei Temperaturen im Bereich von 650 bis 800°C müssen diese Steigrohre in regelmäßigen Abständen mit feuerfesten Oxiden bzw. Nitriden beschichtet werden, um eine zu schnelle Korrosion dieser Werkstoffe im flüssigen Aluminium zu vermeiden. Der Korrosionsmechanismus ist im Falle der Eisenlegierungen ein Lösungsmechanismus, im Falle von fused silica kommt es zur Reaktion von Siliciumdioxid mit dem schmelzflüssigen Aluminium gemäß der Reaktionsgleichung:

3 SiO₂ + 4 Al --> 2 Al₂O₃ + 3 Si.

Es kommt zu Anhaftungen der Reaktionsprodukte und Schmelzereste am Fused Silica-Steigrohr, und unterschiedliche Ausdehnungskoeffizienten zwischen Steigrohr und Korrosionsprodukten führen zum frühzeitigen Versagen des Steigrohrs. Üblicherweise kommen hierbei Beschichtungen aus Aluminiumoxid oder Bornitrid zum Einsatz, welche aus Schlichten, die organische Bindemittel enthalten, durch Tauchen, Pinseln oder Sprühen aufgebracht werden. Durch den kombinierten korrosiven und mechanischen Angriff durch die heiße Schmelze und die aufschwimmende Schlacke ist die Lebensdauer solcher Beschichtungen jedoch auf Stunden bzw. wenige Tage begrenzt. Alternativ zu den beschichteten Steigrohren aus Eisenlegierung oder Quarz kommen auch Steigrohre aus Siliciumnitrid-Keramik zum Einsatz, welche vollkommen inert gegenüber korrosiven Angriffen durch Aluminiumschmelzen sind. Die Kosten dieser Siliciumnitrid-Rohre sind allerdings um ein vielfaches höher als bei den Standard-Steigrohren mit Beschichtung.

### Stand der Technik

Aus EP 963 464 B1 sind mit Siliciumnitrid-Schichten versehene Schmelztiegel aus Quarz. Graphit oder Keramik zur Vermeidung von Verklebungen zwischen Schmelztiegel und Nichteisenmetallen nach Kontakt des Schmelztiegels mit erstarrenden Nichteisenmetallschmelzen, wie Siliciumschmelzen, bekannt, wobei die Schichten aus einem Siliciumnitrid-Pulver hoher Reinheit bestehen. Diese Pulverbeschichtungen werden direkt vom Anwender vor dem Einsatz der Schmelztiegel aufgebracht und dadurch hergestellt, dass man hochreines Siliciumnitrid-Pulver in einem Lösungsmittel dispergiert und dann beispielsweise durch Sprühen der Suspension auf die Tiegel aufbringt. Durch thermische Nachbehandlung müssen das Lösungsmittel und gegebenenfalls eingesetzte organische Binderbestandteile entfernt werden.

Das hochreine Siliciumnitrid selbst erwies sich als chemisch sehr beständig gegenüber Siliciumschmelzen. Allein durch das Gewicht der Schmelze kommt es jedoch zur Zwangsbenetzung bzw. Infiltration der porösen Siliciumnitrid-Pulverschicht. Diese muss daher in einer solchen Dicke ausgebildet werden, dass sie nicht vollständig infiltriert wird und damit immer noch als Trenn- bzw. Entformungsschicht dienen kann. Entsprechend dicke Schichten sind jedoch wiederum entsprechend weich und nicht besonders abriebfest, sodass beim Beladen der Tiegel besondere Sorgfalt angewendet werden muss, ganz zu Schweigen von langen Transportwegen oder dem Versand gebrauchsfertiger beschichteter Tiegel.

Diese herkömmlichen Tiegelbeschichtungen zur Anwendung auf dem Gebiet von Solarsilicium sind somit darin nachteilig, dass die Beschichtungen eine geringe mechanische Stabilität aufweisen, sodass die Beschichtungen immer unmittelbar vor der Beladung der Tiegel mit dem Siliciumpulver, -grus oder -stückgut erfolgen müssen. Eine vorausgehende Beschichtung der Tiegel nicht unmittelbar an der Stelle der Verwendung ist somit nicht möglich. Aufgrund der weichen Pulverbeschichtungen muss weiterhin extreme Sorgfalt beim Beladen der Tiegel mit grobem Stückgut angewandt werden, um eine Beschädigung der Schicht zu vermeiden. Weiterhin kommt es aufgrund der Infiltration der porösen Siliciumnitrid-Pulverschicht mit dem schmelzflüssigen Silicium zu unerwünschten Anbackungen. Ebenso kommt es zu Verschleppungen von Siliciumnitrid in den Silicium-Ingot.

Um diese Probleme zu beheben, wird in WO 2007/039310 A1 ein Schmelztiegel mit einer Beschichtung vorgeschlagen, welche aus 80 bis 95 Gew.-% Siliciumnitrid und 5 bis 20 Gew.-% eines mineralischen Niedertemperaturbinders besteht, wobei der Gesamtsauerstoffgehalt der Beschichtung im Bereich von 5 bis 15 Gew.-% liegt. Bei dem Niedertemperaturbinder handelt es sich vorzugsweise um einen SiO₂-basierten Binder, es kann aber auch Siliciumoxinitrid eingesetzt werden. Der mineralische Niedertemperaturbinder kann jedoch ebenso ein Sol-Gel-Binder oder eine auf der Siliciumchemie basierende organometallische Verbindung sein oder aus SiO₂-Nanopartikeln bestehen. Die Beschichtungen werden bei Temperaturen unterhalb 800°C und vorzugsweise unterhalb 500°C eingebrannt, um die Oxidation des Siliciumnitrids gering zu halten. Hierfür werden drei bevorzugte Beschichtungsmethoden beschrieben.

Bei der ersten Methode (Reaktivschicht) werden Siliciumnitridpulver und organometallische Verbindungen der Siliciumchemie aus der Gruppe, umfassend Siloxane, Tetraethylorthosilikat, Tetraethoxysilan, Polydimethylsilan oder Kombinationen davon, gemischt, anschließend wird ein Tiegel mit dieser Mischung besprüht unter Zuhilfenahme einer reaktiven Flüssigkeit aus der Familie Ammoniumchlorid, Ammoniak und Nitratlösung. Danach wird der Tiegel mit der aufgebrachten Beschichtung auf eine Temperatur unterhalb 500°C erhitzt zur Stabilisierung der Beschichtung.

Bei der zweiten Methode (Binderlösung) wird das Siliciumnitridpulver mit einem SiO₂-basierten Binder aus der Gruppe Silikonöl, Siloxane, Chlorosilan oder Kombinationen davon gemischt, anschließend wird diese Mischung unter Zuhilfenahme einer reaktiven Flüssigkeit aus der Familie der Säuren (Salzsäure, Salpetersäure, Kieselsäure, Siliciumtetrachlorid oder eine andere geeignete Säure) aufgesprüht. Danach wird der beschichtete Tiegel auf eine Temperatur unterhalb 500°C erhitzt, um Reaktionsflüssigkeiten zu entfernen.

Bei der dritten Methode (gesättigte Lösung und Fällung) wird Siliciumnitridpulver mit SiO₂-Submikron- und/oder SiO₂-Nanopartikeln, bevorzugt kolloidales SiO₂, gemischt, anschließend wird diese Mischung auf der Tiegeloberfläche verfestigt durch thermische Reaktion oder auch chemische Reaktion unter Verwendung eines geeigneten Neutralisationsmittels. Danach wird der beschichtete Tiegel auf Temperaturen unterhalb 500°C erhitzt, vorzugsweise vor dem Einsatz.

In der DE 10 2005 050 593 A1 wird eine Schlichte aus Siliciumnitrid und einem Bindemittel beschrieben zur Herstellung einer dauerhaften Hartbeschichtung, wobei das Bindemittel aus nanoskaligen Feststoffpartikeln und/oder Vorstufen davon aus der Herstellung über einen Sol-Gel-Prozess besteht. Die daraus herstellbaren Schichten sind dicht und haben eine gute Haftfestigkeit, allerdings können mit diesen Schlichten defektfreie Beschichtungen nur bis zu einer maximalen Schichtdicke vom etwa 180 µm aufgebracht werden.

Bei den in WO 2007/039310 A1 und DE 10 2005 050 593 A1 beschriebenen Beschichtungsmethoden werden Sole bzw. keramische Vorstufen (wie Salze oder metallorganische Verbindungen) von SiO₂ eingesetzt, ob aktiviert (z.B. mit Säure, Base oder Wasser) oder unaktiviert. Es hat sich jedoch gezeigt, dass es mit diesen Beschichtungsmitteln unvermeidbar zur Bildung von Defekten in der Beschichtung kommt.

Bei der Applikation dieser Beschichtungen über Tauchen, Fluten oder Nass-in-Nass-Sprühen können Schichtdicken größer 180µm nicht aufgebracht werden, ohne dass Risse oder sonstige Defekte entstehen. Defektfreie Beschichtungen hoher Schichtdicke sind jedoch für die Beschichtung von Tiegeln im industriellen Maßstab sehr wichtig, da die Oberflächen der Tiegel eine gewisse Rauigkeit aufweisen und die Oberflächen auch an den höherstehenden Stellen mit einer gewissen Mindestdicke beschichtet sein müssen. Auch für die Beschichtung großer Tiegel ist eine höhere Schichtdicke erforderlich.

Auch ein pulvriger Auftrag (Beschichtung über Sprühen) kann diese Nachteile nicht gänzlich verhindern, wobei ein solcher pulvriger Auftrag zudem den Nachteil der Inhomogenität der Schicht bezüglich Binder- und Porenverteilung (und somit reduzierter Festigkeit) sowie im späteren Prozess bei der Ingoterschmelzung eine Siliciumnitridkontamination (wie bei EP 0 963 464 B1) mit sich bringt.

Zudem ist die Binderkonzentration in der eingebrannten Beschichtung bei Verwendung dieser Art von Niedertemperaturbindern unter Prozessbedingungen industrieller Fertigung nicht reproduzierbar einzustellen, da der Binder sich während der Synthese abhängig von Temperatur, Luftfeuchte und Lagerdauer ständig verändert und sich die Eigenschaften während und nach der Applikation der Siliciumnitridschicht durch Trocknungsgeschwindigkeit, Luftfeuchte und Umgebungstemperatur ständig verändern. Diese Veränderungen des Binders sind auf Hydrolyse- und Kondensationsreaktionen zurückzuführen.

Deutlich schwerer kontrollierbar wird ein solches System, wenn es direkt vor der Synthese oder während der Applikation gemischt oder aktiviert wird (wie bei WO 2007/039310 A1 beschrieben, insbesondere bei den ersten beiden der bevorzugten Beschichtungsmethoden), da aufgrund der hohen Reaktivität der Komponenten ein reproduzierbares Verhalten bezüglich der Binderreaktivität, Bindung, Schrumpfung, Eindiffusion in das Substrat oder Abdampfen von niedermolekularen Vorstufen oder Kondensaten nicht regelbar ist.

Auch kann es bei den Niedertemperaturbindern zum Eindiffundieren des Bindemittels (Sol-Gel, Salze, Vorstufen von SiO₂, Prekursoren) in das poröse Substrat kommen und es können niedermolekulare Komponenten des Binders während der Trocknung verdampfen, so dass die Schichtzusammensetzung in unkontrollierbarer Weise an Bindemittel verarmt. Eine Verarmung der Beschichtung an Binder an der Kontaktfläche zum Tiegel führt vermehrt zu chipping, insbesondere beim Einbrennen der Beschichtung oder beim Prozess der Ingotherstellung.

Die bei den Beschichtungen auftretenden Schichtdefekte, wie Risse senkrecht zur Schichtoberfläche und insbesondere das "chipping" bewirken, dass es während der Ingotherstellung zu Anhaftungen von Silicium am Tiegelmaterial kommen kann. Das "chipping" (schuppiges Absplittern der Beschichtung in der gesamten Tiefe einschließlich möglicherweise von Tiegelmaterial) entsteht durch Risse im Bereich der Kontaktzone von Beschichtung und Substrat, die zu einer lokalen Ablösung der Beschichtung führen. Dadurch kann es beim Einsatz der Tiegel zu Anhaftungen der Metallschmelze an der Tiegelwand kommen, diese können sich noch verstärken, wenn es zur Unterwanderung der Beschichtung durch die Metallschmelze kommt. Die Anhaftungen von Silicium am Tiegelmaterial entstehen insbesondere während der Prozessphase, in der das Silicium im Tiegel flüssig ist. Je größer die Anhaftung ist bzw. je mehr Anhaftungen entstehen, desto größer wird das Risiko, dass Risse im Ingot während der Erstarrung entstehen, was die Ausbeute an verwertbarem Silicium für die Solarzellenherstellung reduziert.

Es hat sich gezeigt, dass z.B. das Siliciumnitridpulver unabhängig vom Hersteller je nach Charge in der Oberflächenaktivität deutlich voneinander abweichen kann. Diese Unterschiede können in einem gewissen Maß durch eine Temperaturbehandlung des Pulvers vor dem Mischen mit einem Niedertemperaturbinder (wie z.B. Binder der Fa. Inomat, TEOS und andere) ausgeglichen werden, jedoch nicht so, dass die gewünschten Eigenschaften der damit hergestellten Siliciumnitrid-haltigen Schichten nicht mehr voneinander abweichen.

Außer den oben bereits aufgeführten Nachteilen gibt es noch einen Nachteil hinsichtlich des Arbeitsschutzes, da in WO 2007/039310 A1 und DE 10 2005 050 593 A1 Prekursoren und reaktive Gruppen in den Beschichtungssuspensionen enthalten sind. Beispielsweise ist das in WO 2007/039310 A1 verwendete lungengängige TEOS eine flüchtige reizende Komponente, ebenso sind die in WO 2007/039310 A1 und DE 10 2005 050 593 A1 eingesetzten Bindemittelkomponenten wie SiO₂-Nanopartikel, Vorstufen von SiO₂-Nanopartikeln oder niedermolekulare polymerische Strukturen aus SiO₂-haltigen metallorganischen Verbindungen lungengängig, die insbesondere bei einer Sprühapplikation eingeatmet oder berührt werden können. Neben einer Absaugung ist (beispielsweise bei der Verarbeitung einer Beschichtungssuspension gemäß Beispiel 1b in WO 2007/039310 A1) zum Arbeitsschutz eine filtrierende Halbmaske FFAP2 gemäß EN 404, sowie als Körperschutz mindestens Handschuhe und Schutzbrille erforderlich.

Die DE 10 2006 003 819 A1 offenbart eine Schlichte zur Herstellung einer dauerhaften Trennschicht, umfassend eine Suspension von Siliciumnitridpartikeln und HDK (hochdisperse Kieselsäure) SiO₂-Pulver. Das HDK SiO₂-Pulver wurde aus einer SiO₂-Vorstufe (SiCl₄) bei hoher Temperatur (Knallgasflamme) hergestellt.

### Aufgabe der Erfindung

Der Erfindung liegt daher die Aufgabe zugrunde, eine Schlichte zur Herstellung einer dauerhaften, fest haftenden Trennschicht auf einem Substrat vorzusehen, welche Trennschicht insbesondere geeignet ist für Anwendungen im Bereich der Solar-Silicium-Verarbeitung, ohne die im Stand der Technik bekannten Nachteile aufzuweisen, insbesondere defektfreie Beschichtungen hoher Schichtdicke mit verbesserter Haftfestigkeit ermöglicht. Andererseits soll eine dauerhafte und kostengünstige Beschichtung für Anwendungen in der Aluminium-Metallurgie vorgesehen werden, wobei insbesondere die Standzeit von Steigrohren verlängert werden soll.

### Zusammenfassung der Erfindung

Die oben genannte Aufgabe wird gelöst durch eine Schlichte zur Herstellung einer dauerhaften, fest haftenden Trennschicht auf einem Substrat gemäß Anspruch 1, einen Formkörper gemäß Anspruch 11, umfassend ein Substrat mit einer dauerhaften, fest haftenden Trennschicht, ein Verfahren zur Herstellung eines solchen Formkörpers gemäß Anspruch 20 sowie die Verwendung eines solchen Formkörpers gemäß den Ansprüchen 21-23. Vorteilhafte bzw. besonders zweckmäßige Ausgestaltungen des Anmeldungsgegenstandes sind in den Unteransprüchen angegeben.

Gegenstand der Erfindung ist somit eine Schlichte zur Herstellung einer dauerhaften, fest haftenden Trennschicht auf einem Substrat, umfassend eine Suspension von Feststoffteilchen, wobei die Feststoffteilchen 67-95 Gew.-% Siliciumnitrid und 5-33 Gew.-% eines SiO₂-basierten Hochtemperaturbindemittels umfassen, wobei die Herstellung der Schlichte die in Anspruch 1 angegebenen Verfahrensschritte umfasst und wobei das siliciumnitrid und das SiO₂- basierte Hochtemperaturbindemittel als Michgranulat vorliegen.

Gegenstand der Erfindung ist weiterhin ein Formkörper, umfassend ein nichtmetallisches Substrat mit einer dauerhaften, fest haftenden Trennschicht, wobei die Trennschicht 67-95 Gew.-% Siliciumnitrid und 5-33 Gew.-% eines SiO₂-basierten Hochtemperaturbindemittels umfasst und einen Gesamtsauerstoffgehalt von 5-21 Gew.-% aufweist, und erhältlich ist durch ein Verfahren, umfassend die Schritte a)Vorsehen eines nichtmetallischen Substrats, b) Auftragen einer erfindungsgemäßen Schlichte auf das Substrat, und c) Härten der aufgetragenen Schlichte durch Einbrennen bei einer erhöhten Temperatur von 700-1300°C, vorzugsweise 1000-1225°C, weiter vorzugsweise 1050°C-1200°C, noch weiter vorzugsweise 1075-1175°C, insbesondere bevorzugt 1100-1150°C, zur Ausbildung der dauerhaften, fest haftenden Trennschicht.

Gegenstand der Erfindung ist weiterhin die Verwendung eines erfindungsgemäßen Formkörpers auf dem Gebiet der korrosiven Nichteisenmetallschmelzen, insbesondere die Verwendung eines Formkörpers in Form eines Schmelztiegels zur Herstellung von Siliciumschmelzen sowie die Verwendung eines Formkörpers in Form eines Steigrohres in der Aluminium-Metallurgie, insbesondere dem Aluminium-Niederdruckguss.

Überraschenderweise hat sich gezeigt, dass sich mit den erfindungsgemäßen Schlichten besonders dicke, defektfreie, gut haftende und nicht pulverige Schichten applizieren lassen. Die Kontamination im Ingot mit Siliciumnitrid ist extrem gering. Im Vergleich zu den pulvrigen Beschichtung gemäß EP 963 464 B1 und auch WO 2007/039310 A1 ist die Kontamination des Si-Ingots mit Siliciumnitrid bei den erfindungsgemäßen Beschichtungen deutlich geringer.

Es hat sich gezeigt, dass die erfindungsgemäßen Schichten dauerhaft und temperaturstabil bei besonders hohen Schichtdicken von bis zu 3 mm auf Substratoberflächen gebunden werden können. Die Schichten sind berührungsfest und nicht pulvrig.

Der Bindeeffekt in den Schichten ist vornehmlich in der Bindewirkung des temperaturbehandelten SiO₂-basierten Bindemittels zu sehen, wobei eine leichte Oxidation des Siliciumnitrids während des Einbrennens die Bindung in der Trennschicht verstärkt. Es wurde festgestellt, dass bei der erfindungsgemäßen Beschichtung die Oxidation des Siliciumnitrids bei den angewandten Einbenntemperaturen an Luft gegenüber einer bindemittelfreien Siliciumnitridbeschichtung gemäß EP 963 464 B1 unter gleichen Prozessbedingungen deutlich reduziert werden kann, wobei der Anteil des oxidierten Siliciumnitrids um 20-50% reduziert werden kann.

Die erfindungsgemäßen Schlichten lassen sich mit den bevorzugten Applikationsmethoden Tauchen, Fluten und Naß-in-Naß-Sprühen aufbringen. Diese Methoden sind deshalb bevorzugt, weil sich damit anders als beim Sprühen (pulvriger Auftrag) homogenere und dichtere Schichten erzeugen lassen. Durch diese Applikationsmethoden wird in den eingebrannten Schichten die Porengröße in der Beschichtung kleiner und die Haft-, Stoß- und Kratzfestigkeit nimmt gegenüber pulverig applizierten Schichten zu. Die Schichten werden berührungsfest und transportstabil und die Kontamination des Ingots mit Schichtbestandteilen nimmt deutlich ab.

Die Schlichten sind lagerstabil und sie können auch mit Wasser als Suspensionsmedium hergestellt werden, was für den Transport und die Verarbeitung vorteilhaft ist, da dann keine Gefahrgüter transportiert werden müssen und da beim Beschichten der Substrate nicht mit brennbaren Stoffen gearbeitet werden muß.

Die erfindungsgemäßen Schichten zeigen gegenüber den in EP 963 464 B1 und WO 2007/039310 A1 beschriebenen Schichten eine bessere Haftfestigkeit auf dem Tiegelmaterial, und sie sind im Unterschied zu diesen herkömmlichen Schichten nicht pulvrig. Außerdem können mit den erfindungsgemäßen Schlichten dichtere Schichten als bei EP 963 464 B1 und WO 2007/039310 A1 hergestellt werden, d.h. Schichten, die keine großen Poren aufweisen.

In der erfindungsgemäßen Beschichtungssuspension liegt das temperaturbehandelte SiO₂-basierte Hochtemperaturbindemittel nicht als nanodisperse Phase oder als Sol oder als keramische Vorstufen oder als Mischungen daraus vor (Precursor, Monomer, fraktale Anhäufungen von Monomeren oder Polykondensat), sondern als dispergierter an Siliciumnitrid anhaftender SiO₂-Feststoff.

Dieser SiO₂-Feststoff unterscheidet sich deutlich in seinen Eigenschaften von dem ursprünglichen Sol. Die Sinteraktivität ist herabgesetzt, so dass es im Gegensatz zu den aus dem Stand der Technik bekannten Beschichtungen mit Niedertemperaturbindemitteln (WO 2007/039310 A1, DE 10 2005 050 593 A1) nicht zu einer starken Versinterung und Schrumpfung des Bindemittels kommt. Damit entstehen weniger Spannungen in der Beschichtung, wodurch deutlich weniger Defekte in der Substratoberfläche oder in der Beschichtung entstehen (sowohl nach dem Beschichten und nach dem Einbrennen als auch während des Prozesses), wie etwa sog. "chipping" (schuppiges Absplittern der Beschichtung in der gesamten Tiefe einschließlich möglicherweise von Tiegelmaterial), oder Risse und Mikrorisse oder auch die Ausbildung ganzer Rissnetzwerke.

Überraschenderweise ist bei einer so hergestellten Schicht abhängig von der Binderkonzentration in der Schicht innerhalb der erfindungsgemäßen Bedingungen (insbesondere wichtig sind dabei die Vorglühtemperatur des Bindemittels und die Einbrenntemperatur der Beschichtung, abhängig von der Binderkonzentration) die Adhäsion der Schicht zum Substrat stärker als die Kohäsion in der Schicht. Überrraschend ist auch, daß trotz der reduzierten Sinteraktivität des Binders die Haftung der Schicht auf dem Substrat sehr gut ist. Diese Erkenntnis ist neu und ermöglicht die Applikation und das Einbrennen von nicht pulverigen defektfreien Schichten mit besonders hohen Schichtdicken und guter Haftfestigkeit zum Substrat.

Die guten Schichteigenschaften führen zu hervorragenden prozessrelevanten Eigenschaften: aufgrund der nicht pulvrigen Schicht kommt es zu keiner bzw. allenfalls einer sehr geringen Kontamination des Silicium-Ingots, die Beschichtung ist schlagunempfindlicher und ermöglicht eine unproblematische stückige Beladung des beschichteten Tiegels. Weiterhin ist auch die Beschichtung großer Tiegel ("Jumbo-Tiegel") möglich, und die Haftung der Beschichtung auf dem Tiegelmaterial ist ausgezeichnet im kompletten Prozesstemperaturbereich des Ingotherstellers. Insbesondere hat die Beschichtung den Vorteil, dass beim Einsatz der beschichteten Tiegel Defekte wie "Chipping", Risse und Inhomogenitäten in der Beschichtung deutlich reduziert werden. Dies wird durch Daten, die bei Ingotherstellern erhoben wurden, wie beispielsweise die Anzahl der Risse im Ingot und die Menge an Fremdeinschlüssen, belegt. Unter anderem geben diese Daten Aufschluss über die Ausbeute an verwertbarem Silicium für die Solarzellenherstellung. Durch die Verwendung der erfindungsgemäßen Schlichte konnte die Anzahl der Risse im Ingot in einer laufenden Produktion im Vergleich zu pulverigen Siliciumnitrid-Schichten unter das produktionsübliche Maß reduziert werden und das bei einer engen Anzahlverteilung der Risse pro Ingot. Auch die Menge an Einschlüssen wurde reduziert. Die Ausbeute und Prozessstabilität während der Ingotherstellung wurden erhöht.

Beim Beladen herkömmlicher Tiegel oder beim Aufschmelzen von brockigem Silicium kann es zu Beschädigungen der Beschichtung kommen, sind nicht schon Inhomogenitäten oder Defekte in der Beschichtung bei der Applikation oder beim Einbrennen entstanden. Aufgrund der geringen Schichtfestigkeit und geringeren Adhäsion zum Substrat bei Beschichtungen gemäß EP 963464 B1 und WO 2007/039310 A1 ist der Schichtabtrag aufgrund von Stoß-, Scher-, Kratz- oder Reibbelastung hoch und es verbleibt eine dünne oder keine Restschicht. Die erfindungsgemäßen Schichten werden durch die mechanische Beanspruchung beim Beladen nicht, oder deutlich weniger beschädigt. Findet doch ein Schichtabtrag statt, ist dieser bei den erfindungsgemäßen Schichten deutlich geringer, so dass die Trennwirkung und Funktion der Schicht gewährleistet bleibt.

Durch die erfindungsgemäß bevorzugte und vereinfachte Auftragung mittels Fluten werden die Zeiten zur Applikation der Beschichtung auf Substratmaterial deutlich reduziert. Typischerweise dauert eine Sprühapplikation zur Herstellung pulveriger Schichten gemäß Stand der Technik auf einem Standard-Solartiegel mit einer Bodenfläche von 690x690 mm² und Wandflächen von 690x400 mm² 20-50 Minuten. Mit der erfindungsgemäßen Beschichtungssuspension dauert die Applikation über Fluten ca. 5-10 Minuten. Ebenfalls beschleunigt werden kann die Applikation durch Sprühen, die typischerweise 10-15 Minuten für einen Standardtiegel beträgt. Das Nass-in-Nass-Sprühen ermöglicht überdies die Verwendung handelsüblicher Glasierroboter.

### Kurze Beschreibung der Zeichnungen

Die Erfindung wird anhand der Zeichnungen näher erläutert. Hierbei zeigen
**Figur 1** die Ergebnisse des Tape-Tests;
**Figur 2a** eine schematische Darstellung einer erfindungsgemäßen, nicht pulvrig aufgetragenen Schicht;
**Figur 2b** eine schematische Darstellung einer pulvrig aufgetragenen Schicht gemäß Stand der Technik;
**Figur 2c** eine schematische Darstellung von Chipping.

### Detaillierte Beschreibung der Erfindung

Das erfindungsgemäß eingesetzte SiO₂-basierte Hochtemperaturbindemittel ist aus SiO₂-Vorstufen abgeleitet und durch Temperaturbehandlung in einem Temperaturbereich von 300-1300°C gemäß Anspruch 1 vorbehandelt worden. Unter SiO₂-Vorstufen sind Materialien zu verstehen, die durch Temperaturbehandlung SiO₂ bilden können.

Vorzugsweise ist das SiO₂-basierte Hochtemperaturbindemittel aus siliciumorganischen SiO₂-Vorstufen aus der Herstellung über einen Sol-Gel-Prozess abgeleitet, weiter vorzugsweise aus einem Nanokomposit aus siliciumorganischen SiO₂-Vorstufen aus der Herstellung über einen Sol-Gel-Prozess, das ebenfalls nanoskalige Feststoffpartikel enthält. Diese SiO₂-Vorstufen bzw. SiO₂-Vorstufen enthaltenden Nanokomposite werden dann durch Temperaturbehandlung in einem Temperaturbereich von 300-1300°C gemäß Anspruch 1 in die SiO₂-basierten Hochtemperaturbindemittel überführt.

Die nanoskaligen Feststoffpartikel sind vorzugsweise aus SiO₂, TiO₂, ZrO₂, Al₂O₃, AlOOH, Y₂O₃, CeO₂, Kohlenstoff und/oder BN oder aus Vorstufen dieser nanoskaligen Feststoffteilchen, welche über den Sol-Gel-Prozess in diese Feststoffteilchen umgewandelt werden, ausgewählt. Insbesondere bevorzugt handelt es sich um SiO₂-Partikel.

Die erfindungsgemäß bevorzugt eingesetzten Nanokomposite und deren Herstellung nach dem Sol-Gel-Verfahren sind im Stand der Technik bekannt, insbesondere aus DE 103 26 815 A1. Hierbei ist es bevorzugt, dass die nanoskaligen Feststoffteilchen mit einem Oberflächenmodifizierungsmittel mit einem Molekulargewicht von weniger als 1.500 oberflächenmodifiziert sind, insbesondere einem Oberflächenmodifizierungsmittel, das eine Anhydridgruppe, Säureamidgruppe, Aminogruppe, SiOH-Gruppe, hydrolysierbare Reste von Silanen und/oder eine β-Dicarbonylgruppe enthält.

Gemäß einer bevorzugten Ausführungsform ist ein solches Nanokomposit erhältlich nach dem Sol-Gel-Verfahren durch Umsetzen von nanoskaligen Feststoffpartikeln mit einem oder mehreren Silanen der allgemeinen Formel (I):

RₓSiA₍₄₋ₓ₎ (I)

worin die Reste A gleich oder verschieden sind und Hydroxylgruppen oder hydrolysierbare Gruppen darstellen, die Reste R gleich oder verschieden sind und nichthydrolysierbare Gruppen darstellen und x den Wert 0, 1, 2 oder 3 hat, wobei bei mindestens 50% der Stoffmenge der Silane x ≥ 1 ist. Sofern nur Silane der Formel (I) mit x=0 verwendet werden, gelangt man zu rein anorganischen Nanokompositen, ansonsten werden die bevorzugten organisch-anorganischen Nanokomposite erhalten. Diese Nanokomposite werden durch Temperaturbehandlung in einem Temperaturbereich von 300-1300°C gemäß Anspruch 1 in die SiO₂-basierten Hochtemperaturbindemittel überführt.

Gemäß einer anderen Ausführungsform ist das SiO₂-basierte Hochtemperaturbindemittel erhältlich nach dem Sol-Gel-Verfahren durch Umsetzung von einem oder mehreren Silanen der obigen allgemeinen Formel (I) und Temperaturbehandlung des erhaltenen Umsetzungsprodukts in einem Temperaturbereich von 300-1300°C gemäß Anspruch 1.

Geeignete Beispiele von Silanen der obigen Formel (I) sind ebenfalls in der DE 103 26 815 A1 aufgeführt. Insbesondere werden als SiO₂-Vorstufen alkoholische SiO₂-bildende Sole, in denen hochreines Siliciumnitridpulver dispergiert wird, eingesetzt. Die Verwendung hochreiner Ausgangschemikalien (Siliciumnitridpulver, Silane, Alkohole etc.) ist bevorzugt, da hierbei höchstreine Schichten erhalten werden können, die insbesondere den Anforderungen der Solarindustrie gerecht werden.

Das erfindungsgemäß eingesetzte SiO₂-basierte Hochtemperaturbindemittel ist ein durch Temperaturbehandlung in einem Temperaturbereich von 300-1300°C, vorzugsweise 700-1150°C, weiter vorzugsweise 800-1050°C gemäß Anspruch 1, vorbehandeltes und dadurch in seiner Sinteraktivität eingestelltes, das heißt in seiner Sinteraktivität verringertes, SiO₂-basiertes Bindemittel.

Bei der erfindungsgemäßen Schlichte handelt es sich um eine Suspension von Feststoffteilchen, wobei die Feststoffteilchen vorzugsweise 75-90 Gew.-% Siliciumnitrid und 10-25 Gew.-% des SiO₂-basierten Hochtemperaturbindemittels, weiter vorzugsweise 80-88 Gew.-% Siliciumnitrid und 12-20 Gew.-% des SiO₂-basierten Hochtemperaturbindemittels, umfassen.

In der erfindungsgemäßen Schlichte liegen sowohl das Siliciumnitrid als auch das SiO₂-basierte Hochtemperaturbindemittel als Mischgranulat vor.

Bei einem erfindungsgemäßen Formkörper weist die Trennschicht einen Gesamtsauerstoffgehalt von 5-21 Gew.-% auf. Der Sauerstoffgehalt wird in die Trennschicht im wesentlichen durch das SiO₂-basierte Bindemittel eingebracht. Wenn der Gesamtsauerstoffgehalt weniger als 5 Gew.-% beträgt, verschlechtern sich insbesondere die mechanischen Eigenschaften der Siliciumnitrid-haltigen Beschichtung, wie Haft-, Stoß-, Abrieb- und Kratzfestigkeit, deutlich. Die Anbindung am Substrat verringert sich und der Effekt der höheren Adhäsionskräfte im Vergleich zu den Kohäsionskräften verringert sich. Insbesondere ist es zur Erzielung guter mechanischer Eigenschaften vorteilhaft, wenn der Gesamtsauerstoffgehalt 6-18 Gew.-%, weiter vorzugsweise 7-15 Gew.-%, beträgt. Wenn andererseits der Gesamtsauerstoffgehalt über 21 Gew.-% beträgt, besteht die Gefahr, dass die mit der Siliciumnitrid-haltigen Beschichtung in Berührung kommenden Nichteisenmetallschmelzen durch Lösung von Sauerstoff in den Schmelzen verunreinigt werden und die Trennwirkung der Beschichtung gegenüber den Nichteisenmetallschmelzen abnimmt.

Weiterhin ist es möglich, die Trennschicht als Mehrfachschicht auszubilden, wobei die vom Substrat abgewandte äußerste Schicht dann die oben beschriebene Zusammensetzung aufweist und einen Gesamtsauerstoffgehalt von maximal 21 Gew.-%, vorzugsweise maximal 12 Gew.-% aufweist. Gemäß einer Ausführungsform ist hierbei die Trennschicht als Doppelschicht ausgebildet, umfassend eine erste, auf das Substrat aufgebrachte Schicht mit einem Gesamtsauerstoffgehalt von maximal 27 Gew.-%, vorzugsweise maximal 16 Gew.-%, sowie eine darüberliegende zweite Schicht der obigen Zusammensetzung mit einem Gesamtsauerstoffgehalt von maximal 21 Gew.-%, vorzugsweise maximal 12 Gew.-%. Bei dieser Zweifachbeschichtung dient die erste Schicht als Haftvermittlerschicht, sie hat eine höhere Festigkeit als die Deckschicht darüber. Falls es doch zu Beschädigungen der oberen Schicht kommt, wird durch die untere Schicht der Kontakt der Metallschmelze mit dem Tiegel auf jeden Fall vermieden. Zudem ist der Wärmeausdehnungskoeffizient der unteren Schicht geringer als der der Deckschicht, so dass dadurch eine bessere Anpassung der Beschichtung an das Tiegelmaterial hinsichtlich der Wärmeausdehnung erreicht wird. Dies ist von Vorteil bei Prozessen mit schroffen Temperaturwechseln. Mehrfachschichten zur weiteren Abstufung des Gradienten sind ebenfalls möglich, wobei die Grenzen für die obere und untere Schicht erhalten bleiben.

Bei den erfindungsgemäßen Formkörpern besteht das nichtmetallische Substrat geeigneterweise aus Quarz, Graphit, Keramik (einschließlich Siliciumnitrid-Keramik) oder SiO₂ (fused silica) oder auch Fasermatten oder Gewebe. Bei einer bevorzugten Ausführungsform handelt es sich bei dem Formkörper um einen Schmelztiegel mit einem Substrat aus Quarz, Graphit, Keramik oder SiO₂ (fused silica), welcher sich für die Verarbeitung korrosiver Nichteisenmetallschmelzen, insbesondere Siliciumschmelzen eignet.

Gemäß einer anderen Ausführungsform handelt es sich bei dem Formkörper um ein Steigrohr mit einem Substrat aus SiO₂ (fused silica) für die Aluminium-Metallurgie.

Die Trennschicht der erfindungsgemäßen Formkörper weist vorzugsweise eine Dicke von 80-3000 µm, weiter vorzugsweise 150-2000 µm, noch weiter vorzugsweise 200-500 µm, auf.

Die erfindungsgemäßen Formkörper sind erhältlich durch ein Verfahren, das die folgenden Schritte umfasst:
a) Vorsehen eines nichtmetallischen Substrats,
b) Auftragen einer erfindungsgemäßen Schlichte auf das Substrat, und
c) Härten der aufgetragenen Schlichte durch Einbrennen bei einer erhöhten Temperatur von 700-1300°C, vorzugsweise 1000-1225°C, weiter vorzugsweise 1050-1200°C, noch weiter vorzugsweise 1075-1175°C, insbesondere bevorzugt 1100-1150°C zur Ausbildung der dauerhaften, fest haftenden Trennschicht.

Ein bevorzugtes Gesamtverfahren, bei dem auch die Herstellung der erfindungsgemäßen Schlichte integriert ist, umfasst die folgenden Verfahrensschritte:
1) Mischen von Vorstufen des SiO₂-basierten Hochtemperaturbindemittels zusammen mit Siliciumnitridpulver und gegebenenfalls Hilfsstoffen zur Erzielung eines Vorprodukts 1,
2) Granulation des Vorprodukts 1 zur Erzielung eine Granulats als Vorprodukt 2,
3) Temperaturbehandlung des Vorprodukts 2 in einem Temperaturbereich von 300-1300°C zur Erzielung eines temperaturbehandelten Granulats als Vorprodukt 3,
4) Aufmahlung des Vorprodukts 3 zur Einstellung der Partikelgröße,
5) Dispergieren des in Schritt 4) erhaltenen Produkts, gegebenenfalls Zusatz von Siliciumnitridpulver, für den Fall, dass dieses im Schritt 1) nicht vollständig eingesetzt wurde, sowie weiterhin gegebenenfalls Zusatz von organischen und anorganischen Bindemitteln zur Herstellung einer Suspension (Schlichte) als Vorprodukt 4,
6) Auftragen des Vorprodukts 4 auf ein Substrat, und
7) Herstellung eines erfindungsgemäßen Formkörpers durch Einbrennen der Beschichtung.

Als Siliciumnitridpulver in den Schritten 1) und/oder 5) wird bevorzugt ein Pulver hoher Reinheit eingesetzt, dessen Alkali- und Erdalkalimetallgehalt jeweils maximal 1000 ppm und dessen Fluorid- und Chloridgehalt jeweils maximal 2000 ppm, dessen Gesamtkohlenstoffgehalt ebenfalls maximal 2000 ppm und dessen mittlere Partikelgröße d₅₀ maximal 5 µm beträgt. Der Sauerstoffgehalt solcher Siliciumnitrid-Pulver hoher Reinheit liegt üblicherweise im Bereich von 1 bis 1,5 Gew.-%.

Die Vorstufen in Schritt 1) sind vorzugsweise die bereits oben erwähnten Nanokomposite aus Vorstufen des Siliciumdioxides oder Siliciumnitrids, wie z.B. metallorganische Verbindungen oder Salze des Siliciums, ggf. mit Zusatz von Siliciumoxid-Nanopartikeln. Diese werden zusammen mit Siliciumnitridpulver homogen gemischt, z.B. in einer Naßaufmahlung oder anderen Mischaggregaten.

Die Hilfsstoffe in Schritt 1) können organische Verbindungen wie z.B. Polyvinylbutyral (PVB), Polyvinylalkohol (PVA), Polyethylenglykol (PEG), Wachse oder ethanollösliche Polymere sein.

Die Granulation in Schritt 2) erfolgt über z.B. Fällen in einer Flüssigkeit, z.B. Wasser oder Öl, oder Sprühtrocknen oder andere Granulationstechniken.

Die Suspension aus dem Vorprodukt 1 wird in gängigen Granulationsverfahren zu einem Granulat (Vorprodukt 2) verarbeitet, wobei die Suspension in einem geeigneten Behälter getrocknet und ein brockiges Vorprodukt 2 hergestellt wird, bevorzugt die Granulation in einem Mischaggregat, wie z.B. Eirichmischer, durchgeführt wird und ein Granulat mit einer Granulatgröße zwischen 50µm und mehreren Millimetern hergestellt wird, weiter bevorzugt die Granulation durch Fällung in einer Flüssigkeit erfolgt, in der das Vorprodukt 1 unlöslich oder nur schwer löslich ist (oder nur partiell löslich ist) und das gefällte Granulat eine Granulatgröße von 10µm bis bevorzugt wenige Millimeter besitzt, und besonders bevorzugt die Granulation durch Sprühtrocknen oder Sprüh-Aufbaugranulation erfolgt, wobei die Granulatgröße wenige µm bis ca. 150µm oder 20 bis ca. 500µm beträgt.

Die Temperaturbehandlung des Granulats in Schritt 3) bei Temperaturen oberhalb 300°C führt zu einer Entfernung der organischen Hilfsstoffe (Entbinderung), und bei Temperaturen von 450°C bis 1300°C (Glühen) zu einer Verfestigung des Granulats.

Die Entfernung der organischen Hilfsstoffe bei Schritt 3), welche nachfolgend auch als "Entbinderung" bezeichnet wird, findet an Luft bei Temperaturen zwischen 300°C und 550°C statt, bevorzugt bei 350°C - 500°C und insbesondere bevorzugt bei 400°C - 450°C. Die Entbinderung kann im Batch-Verfahren in Tiegeln (z.B. Fused Silica) oder bevorzugt im Drehrohrofen erfolgen.

Ebenfalls in Schritt 3) erfolgt die Glühung des entbinderten Granulats, vorzugsweise zwischen 450°C und 1300°C, weiter bevorzugt zwischen 450°C - 1200°C und insbesondere bevorzugt bei 750°C - 1150°C. Zur Einstellung optimaler Schichteigenschaften der eingebrannten Beschichtung ist eine geeignete Glühtemperatur des Granulats abhängig vom Bindergehalt des Granulats einzustellen. Die Verwendung einer Mischung aus unterschiedlich hoch geglühten Granulaten ist ebenfalls möglich.

Prinzipiell gilt, für höhere Bindergehalte werden höhere Einbrenntemperaturen gewählt. Z.B. beträgt für einen Bindergehalt im Granulat von 15 Gew.-% eine geeignete Glühtemperatur des Granulats 500-1000°C. bevorzugt 600-900°C und besonders bevorzugt 750-850°C. Bei einem Bindergehalt von z.B. 24 Gew.-% im Granulat beträgt eine geeignete Glühtemperatur des Granulats 600-1100°C, bevorzugt 700-1000°C und besonders bevorzugt 850-950°C.

Das Vorprodukt 3 enthält das durch die Temperaturbehandlung entstandene, erfindungsgemäße Hochtemperaturbindemittel zusammen mit Siliciumnitrid.

Die Aufmahlung des Granulats im Schritt 4) dient zur Einstellung der Partikelgröße, vorzugsweise einer mittleren Partikelgröße d₅₀ von maximal 30 µm, weiter vorzugsweise 1-15 µm, noch weiter vorzugsweise 1,5-10 µm und insbesondere bevorzugt von 2-8 µm.

Die Aufmahlung des Granulats in Schritt 4) führt ebenfalls bevorzugt zu einer bimodalen Granulatgrößenverteilung.

Die Dispergierung in Schritt 5) kann in einem separaten Verfahrensschritt erfolgen oder direkt bei der Aufmahlung in Schritt 4) in einem organischen oder anorganischen Lösemittel, vorzugsweise einem Alkohol und/oder Wasser. Hierbei können zur Erhöhung der Stabilität der Suspension oder der Grünfestigkeit der applizierten Schicht anorganische oder organische Zusätze, z.B. PVB, PVA, PEG, Wachse oder ethanollösliche Polymere verwendet werden.

Bei Schritt 5) können ebenfalls noch zusätzliche Komponenten zugemischt werden, wie etwa nanoskalige Feststoffpartikel und/oder Vorstufen davon aus der Herstellung über einen Sol-Gel-Prozess, bevorzugt Siliciumdioxid-oder Siliciumnitrid-bildende Nanopartikel bzw. Vorstufen davon oder auch Siliciumoxinitrid. Der Anteil an aus den zugesetzten Partikeln bzw. Vorstufen resultierendem SiO₂-Gehalt in der Schlichte sollte nicht mehr als 3 Gew.-% betragen, um die Eigenschaften der erfindungsgemäßen Beschichtungen nicht zu beeinträchtigen.

Bei der erfindungsgemäßen Herstellung der Schlichte kann die Berührung oder das Einatmen von flüchtigen, reizenden oder giftigen Stoffen in der Prozesskette in geschlossenen Systemen minimiert bzw. ausgeschlossen werden. Findet beispielsweise die Granulation in einem Sprühturm statt, können durch die Verwendung einer nachgeschalteten Kondensationsanlage die Belastungen von Umwelt und Mensch minimiert werden, indem flüchtige Komponenten aufgefangen und im Prozess recycelt werden. Gleiches gilt für die Entbinderung, in der eine Nachverbrennung flüchtige Komponenten oxidiert. Anders als in WO 2007/039310 A1 und DE 10 2005 050 593 A1 enthalten die bevorzugten, erfindungsgemäßen, siliciumnitridhaltigen Schlichten keine reizenden oder gefährdenden Komponenten und sind durch Glühung und Granulation in der Schlichte so groß und nicht lungengängig, dass für den Arbeitsschutz bei der Applikation der Schicht durch Sprühen bei vorhandener Absaugung nur eine einfache Halbmaske FFP2 gem. EN 149:2001 zu empfehlen ist. Dies bedeutet, dass für die Arbeitsschritte der Applikation und des nachfolgenden Handling (Prozessschritte mit höchster Aussetzungsdauer für Personal) auch bei geringem Automatisierungsgrad keine bzw. nur geringe gesundheitliche Risiken existieren.

Die Applikation in Schritt 6) der hergestellten Suspension erfolgt mit gängigen Beschichtungsverfahren wie Sprühen, bevorzugt nass in nass, oder Fluten auf einem anorganischen Substrat, wie z.B. Fused Silica. Nach der Applikation kann die Beschichtung an Luft getrocknet werden.

Die Herstellung des beschichteten Formkörpers in Schritt 7) erfolgt durch Einbrennen der Beschichtung bei einer erhöhten Temperatur, von 700°C bis 1300°C, bevorzugt bei 1000°C - 1225°C, weiter bevorzugt bei 1050°C - 1200°C. weiter bevorzugt bei 1075°C - 1175°C und besonders bevorzugt bei 1100-1150°C, jeweils vorzugsweise mit einer Aufheiz- und Abkühlzeit von vorzugsweise jeweils 8 Stunden und einer Haltezeit bei Maximaltemperatur von vorzugsweise einer Stunde unter Luft, oder bei reduzierender oder inerter Atmosphäre oder unter Gasdruck, z.B. Stickstoff oder Argon. Ein Einbrennen der Beschichtung unter reduzierender Atmosphäre, z.B. in einem gasbefeuerten Ofen mit reduzierender Atmosphäre oder niedrigem Sauerstoffpartialdruck, ist bevorzugt, da dann das Siliciumnitrid in der Beschichtung weniger stark oxidiert.

Bei Verwendung der Schlichten zur Beschichtung von Substraten für die Al-Metallurgie kann das eingesetzte Siliciumnitridpulver auch von geringerer Reinheit sein als für die Anwendung beim Schmelzen von Solar-Silicium.

Der Feststoffgehalt in der Beschichtungssuspension liegt für die Applikation durch Fluten geeigneterweise bei 40 bis 65 Gew.% und für die Applikation durch Nass-in-Nass-Sprühen bei 35 bis 55 Gew.%.

Die erfindungsgemäßen Formkörper mit einer dauerhaften, fest haftenden Trennschicht eignen sich auf dem Gebiet der korrosiven Nichteisenmetallschmelzen, wie Schmelzen von Aluminium, Silicium und dergleichen. Formkörper in Form von Schmelztiegeln eignen sich insbesondere zur Herstellung von Siliciumschmelzen, zur Aufnahme von flüssigem Silicium und zur Kristallisation von flüssigem Silicium zu Siliciumblöcken.

Formkörper in der Form von Steigrohren eignen sich insbesondere in der Aluminium-Metallurgie, ganz besonders dem Aluminium-Niederdruckguss.

### Beispiele und Vergleichsbeispiele

In den Beispielen und Vergleichsbeispielen beziehen sich die angegebenen Schichtdicken auf die Trockenschichtdicken nach dem Einbrennen.

### Tape-Test:

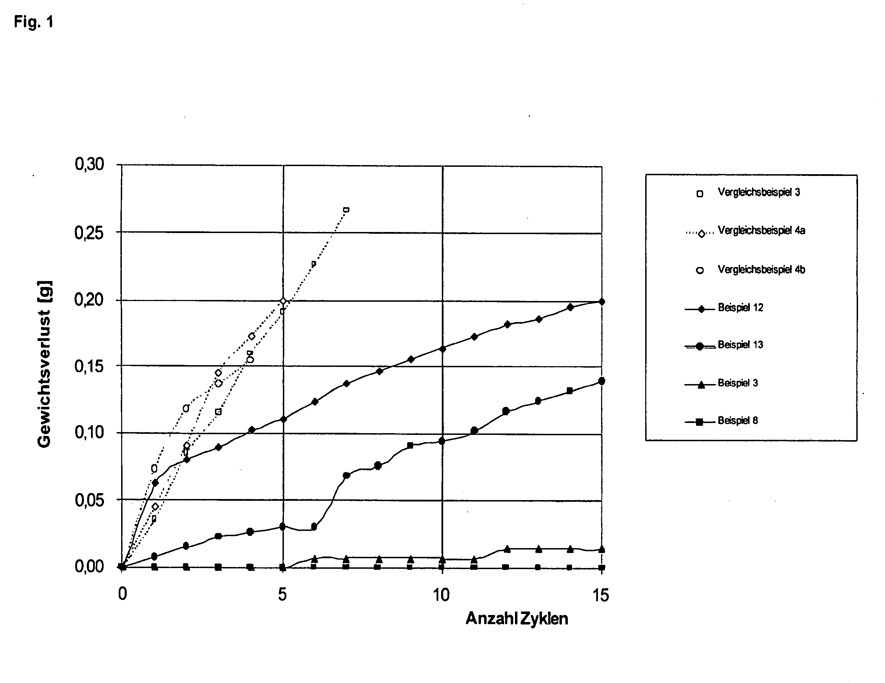

Der Tape-Test wird durch mehrmaliges Aufkleben und Abziehen eines Klebebandes (Tesa 4651) auf einer definierten beschichteten Probenfläche von 1000 mm² ausgeführt. Das Abziehen des Klebestreifens erfolgte im 90°-Winkel zur Probenoberfläche. Der Test der Beschichtungen wurde so lange durchgeführt, bis erste Bereiche des Substratmaterials nicht mehr durch die Beschichtung abgedeckt wurden bzw. nach 15-maliger Wiederholung des Tests. Nach jedem Abziehen des Klebebandes wurde der Gewichtsverlust der Probe bestimmt. Die Anzahl der Wiederholungen des Abzugstests wurden in einem Diagramm gegen den Gewichtsverlust aufgetragen (Figur 1).

Mit sinkender Festigkeit der Schicht, wie bei pulverigen Schichten und/oder pulverig aufgetragenen Beschichtungen, ist der messbare Abtrag größer (Gewichtsverlust), und das Risiko höher, dass mehr Beschichtungsmaterial in die Schmelze verschleppt wird, mehr Beschichtungsmaterial bei mechanischen Belastungen abgetragen wird und die Schicht schneller verbraucht ist, so dass keine Trennwirkung mehr vorhanden ist.

### Abzugstest (Haftfestigkeit):

Die Haftfestigkeit wurde durch die Messung der Kraft, die zum Abzug einer auf die eingebrannte Beschichtung einer beschichteten Probe geklebte Platte benötigt wird, durchgeführt (Klebefläche 500 mm²). Die Platte wurde mit einem Zweikomponenten-Epoxidharzkleber aufgeklebt, der durch seine hohe Viskosität maximal 50-80 µm in die Beschichtungen eindringt. Ermittelt wurde die Haftfestigkeit senkrecht zur Schichtoberfläche in N/mm². Nach dem Abzugstest wurde die Bruchfläche untersucht und bewertet, ob der Bruch in der Beschichtung (Kohäsion) oder in der Kontaktfläche zum Substrat (Adhäsion) entstand. Die Schichtdicke der getesteten beschichteten Proben lag zwischen 250 und 450 µm.

Der Abzugstest gibt Aufschluss über die Adhäsion der Schicht am Substrat, bzw. über die Festigkeit der Schicht im Falle dessen, dass die Adhäsionskräfte die Kohäsionskräfte überschreiten, was wie zuvor erläutert ein erwünschter Effekt ist.

### Vergleichsbeispiel 1: Standardsuspension

Hierbei handelt es sich um eine gemäß EP 963 464 B1 hergestellte Suspension von Siliciumnitrid-Pulver (UBE E 10) in dest. Wasser ohne weitere Zusätze.

Für die weitere Verarbeitung (Pinseln, Rollen, Sprühen) ist nur die Rheologie dieser Suspension ausschlaggebend. Dementsprechend wird der Feststoffgehalt eingestellt, beispielsweise 30 Gew.-% für die Applikation mittels Sprühpistole.

Die Suspension wird auf einen gereinigten, staubfreien, trockenen Fused-Silica-Tiegel ggf. in mehreren Schichten aufgebracht, um eine homogene Schichtdicke von 350 µm zu erzeugen. Nach Trocknung wird die Beschichtung vor dem Einsatz als Schmelztiegel bei 900°C eingebrannt.

Die erhaltene Siliciumnitrid-Pulverbeschichtung sollte blasen- und rissefrei sein und auch keine anderen Defekte aufweisen. Die so hergestellte Siliciumnitrid-Schicht ist nur bedingt berührungsfest und sollte entsprechend sorgsam behandelt werden. Nicht nur beim Beladen mit stückigem Si muss eine Verletzung der Beschichtung vermieden werden, sondern die Beladung muss auch selber dermaßen erfolgen, dass beim Erschmelzen das Verrutschen von stückigem Si vermieden wird, damit hier ebenfalls keine Defekte in der Pulverschicht erzeugt werden.

### Vergleichsbeispiel 2: Standardsuspension

Es werden 50 Gew.-% Siliciumnitridpulver (UBE E10) in Ethanol homogenisiert. Die Suspension wird auf einen gereinigten, staubfreien, trockenen Fused-Silica-Tiegel aufgebracht. Die Beschichtung des Tiegels mittels Fluten ist nicht möglich, da bereits ab einer Schichtdicke von 150-200µm in der Beschichtung während der Trocknung Risse entstehen, was zu einer flächigen Ablösung der Beschichtung vor dem Einbrennen der Beschichtung führt. Die Benetzung des Tiegels mit Ethanol vor der Applikation konnte diesen Effekt nicht verhindern. Auch bei der Zugabe von 2% PVA Celvol E 04/88 (Celanese Emulsions GmbH) in die Ethanol-Siliciumnitrid-Suspension können keine rissfreien Schichtdicken von >250 µm bei einer Applikation per Fluten oder Nass-in-Nass-Sprühen erzielt werden.

### Vergleichsbeispiel 3: Standardsuspension

Es werden 50 Gew.-% Siliciumnitridpulver (UBE E10) in Ethanol homogenisiert. Die Suspension wird auf einen gereinigten, staubfreien, trockenen Fused-Silica-Tiegel aufgebracht. Die Beschichtung wird durch Sprühen aufgetragen. Es zeigte sich, dass ein Nass-in-Nass-Sprühen der Suspension nicht möglich ist, da ab einer Schichtdicke von ca. 200 µm Risse in der Beschichtung entstehen. Die Beschichtungen werden pulverig aufgesprüht.

Nach der Trocknung werden die Beschichtungen vor dem Einsatz als Schmelztiegel bei ca. 1000°C eingebrannt. Die so hergestellte SiliciumnitridSchicht ist nur bedingt berührungsfest und sollte entsprechend sorgsam behandelt werden.

Die Haftfestigkeit der Beschichtung beträgt 0,21 N/mm², die Ergebnisse des Tape-Tests sind in Fig. 1 dargestellt.

Die Beschichtungssuspension wurde außerdem über Fluten aufgetragen, hier reißt die Beschichtung bereits beim Trocknen oder Einbrennen und löst sich plattig ab. Daher konnte hier keine Haftfestigkeit gemessen werden (s. Tabelle 1).

### Vergleichsbeispiele 4a und 4b:

Es wurde eine Beschichtunssupension hergestellt gemäß WO 2007/039310 A1, Beispiel 1b. Die Beschichtung wurde über pulvriges Sprühen oder Nass-in-Nass-Sprühen aufgetragen und bei 500°C (4a) oder 750°C (4b) eingebrannt. Sowohl beim pulvrigen Sprühen als auch beim Nass-in-Nass-Sprühen handelt es sich um Sprühen mittels reaktiver Flüssigkeit wie in WO 2007/039310 A1 angegeben.

Die Beschichtung ist nach dem Einbrennen pulvrig und nicht berührungsfest. Für die pulvrig aufgesprühten Beschichtungen ist die Haftfestigkeit der Beschichtung in Tabelle 1 angegeben, die Ergebnisse des Tape-Tests sind in Fig. 1 dargestellt.

Bei der Beschichtung über Nass-in-Nass-Sprühen reißt die Beschichtung bei einer Schichtdicke von >80 - 150 µm bereits beim Trocknen oder Einbrennen und löst sich ab, daher konnte hier keine Haftfestigkeit gemessen werden.

### Ver_gleichsbeispiel 5:

Das Vorprodukt 1 wird durch Homogenisierung von 930g Ethanol, 150g hochdisperser Kieselsäure (HDK, Wacker), 474g Siliciumnitrid-Pulver (UBE E10) und 16g PVB mit Siliciumnitrid-Mahlkugeln in einem PE-Behälter auf dem Rollenbock hergestellt. Das Vorprodukt 2 wird durch Ausgießen von Vorprodukt 1 in einem flachen PE-Behälter und Trocknung im explosionsgeschützten Trockenschrank hergestellt. Das brockige Granulat wird bei 450°C an Luft in einem Fused-Silica-Tiegel entbindert. Zur Herstellung von Vorprodukt 3 wird das Granulat durch Temperaturbehandlung bei 900°C in einem abgedeckten Tiegel geglüht. 750g Ethanol und 750g des Vorprodukts 3 werden in einem PE-Behälter mit Mahlkugeln gemahlen und homogenisiert zur Herstellung von Vorprodukt 4. Die mittlere Partikelgröße von Vorprodukt 4 liegt bei < 1µm. Das Vorprodukt 4 wird per Fluten auf einem Fused Silica-Tiegel mit einer Schichtdicke von ca. 250 µm appliziert. Die Schicht wird 24h an Luft getrocknet und anschließend mit einer Aufheiz- und Abkühlzeit von 8 Stunden bei 1125°C eingebrannt.

Die Beschichtung ist nach dem Einbrennen nicht berührfest.

### Vergleichsbeispiel 6:

Das Vorprodukt 1 wird durch Homogenisierung von 650g Ethanol, 150g Fused Silica (d₅₀ = 2µm), 474g Siliciumnitrid-Pulver (UBE E10) und 16g PVB mit Siliciumnitrid-Mahlkugeln in einem PE-Behälter auf dem Rollenbock hergestellt. Das Vorprodukt 2 wird durch Ausgießen von Vorprodukt 1 in einem flachen PE-Behälter und Trocknung im explosionsgeschützten Trockenschrank hergestellt. Das brockige Granulat wird bei 450°C an Luft in einem Fused-Silica-Tiegel entbindert. Zur Herstellung von Vorprodukt 3 wird das Granulat durch Temperaturbehandlung bei 900°C in einem abgedeckten Tiegel geglüht. 500g Ethanol und 750g des Vorprodukts 3 werden in einem PE-Behälter mit Mahlkugeln gemahlen und homogenisiert zur Herstellung von Vorprodukt 4. Die mittlere Partikelgröße von Vorprodukt 4 liegt bei 2µm. Das Vorprodukt 4 wird per Fluten auf einem Fused-Silica-Tiegel mit einer Schichtdicke von ca. 350 µm appliziert. Die Schicht wird 24h an Luft getrocknet und anschließend mit einer Aufheiz- und Abkühlzeit von 8 Stunden bei 1125°C eingebrannt.

Die Beschichtung ist nach dem Einbrennen nicht berührfest.

### Beispiel 1:

Das Vorprodukt 1 wird durch Homogenisierung von 3000g Inosil S-B (Type Inosil S-B 38, Fa. Inomat GmbH; bei diesem kommerziell erhältlichen Binder handelt es sich um eine Mischung von siliciumorganischen Verbindungen, also SiO₂-Vorstufen, und SiO₂-Nanopartikeln), 1000g Ethanol, 4000g Siliciumnitridpulver (UBE E10) und 400g PVB (Polyvinylbutyral BM 18, Wacker) mit Siliciumnitrid-Mahlkugeln in einem PE-Behälter auf dem Rollenbock hergestellt.

Das Vorprodukt 2 wird durch Ausgießen von Vorprodukt 1 in einem flachen PE-Behälter und Trocknung im explosionsgeschützten Trockenschrank hergestellt. Das brockige Granulat wird bei 450°C an Luft in einem Fused-Silica-Tiegel entbindert. Zur Herstellung von Vorprodukt 3 wird das Granulat in einer Temperaturbehandlung bei 900°C in einem abgedeckten Tiegel eine Stunde geglüht. 500g Ethanol und 750g des Vorprodukts 3 werden in einem PE-Behälter mit SN-Mahlkugeln gemahlen und homogenisiert zur Herstellung von Vorprodukt 4. Die mittlere Partikelgröße von Vorprodukt 4 liegt bei 4µm. Das Vorprodukt 4 wird durch einmaliges Fluten auf einem Fused Silica-Tiegel mit einer Schichtdicke von ca. 300 µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig. Der Bindergehalt in der Beschichtung beträgt 20 Gew.-%.

### Beispiel 2:

Das Vorprodukt 1 wird durch Homogenisierung von 3000g Inosil S-B, 1000g Ethanol, 4000g UBE E 10 und 100g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 900°C in einem abgedeckten Tiegel eine Stunde geglüht. 500g Ethanol und 750g des Vorprodukts 3 werden in einem PE-Behälter mit Mahlkugeln gemahlen und homogenisiert zur Herstellung von Vorprodukt 4. Die mittlere Partikelgröße von Vorprodukt 4 liegt bei 5-6µm. Das Vorprodukt 4 wird durch einmaliges Fluten auf einem Fused Silica-Tiegel mit einer Schichtdicke von ca. 300 µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig. Der Bindergehalt in der Beschichtung beträgt 20 Gew.-%.

### Beispiel 3:

Das Vorprodukt 1 wird durch Homogenisierung von 3000g Inosil S-B, 1000g Ethanol, 4000g UBE E 10 und 100g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 900°C in einem abgedeckten Tiegel eine Stunde geglüht. 600g Ethanol und 750g des Vorprodukts 3 werden in einem PE-Behälter unter Zugabe von 75g PEG 400 und 75g PVB mit Mahlkugeln gemahlen und homogenisiert zur Herstellung von Vorprodukt 4. Die mittlere Partikelgröße von Vorprodukt 4 liegt bei 5µm. Das Vorprodukt 4 wird mittels Sprühen nass in nass auf einem Fused Silica-Tiegel mit einer Schichtdicke von ca. 350µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig.

Die Haftfestigkeit der Beschichtung ist in Tabelle 1 dargestellt, die Ergebnisse des Tape-Tests in Fig. 1. Die Dichte der Beschichtung beträgt 1,20 g/cm³. Der Bindergehalt in der Beschichtung beträgt 20 Gew.-%.

### Beispiele 4 - 7:

Die Beispiele 4 bis 7 wurden gemäß Beispiel 2 hergestellt, jedoch wurden die Glühtemperatur des Granulats und die Einbrenntemperatur der Schicht gemäß Tabelle 1 variiert.

Die Beschichtungen sind defektfrei und nicht pulvrig. Die Haftfestigkeit der Beschichtungen ist in Tabelle 1 gezeigt. Der Bindergehalt in den Beschichtungen beträgt 20 Gew.-%.

### Beispiel 8:

Das Vorprodukt 1 wird durch Homogenisierung von 4500g Inosil S-B, 4800g UBE E 10 und 160g PVB mit Siliciumnitrid-Mahlkugeln in einem PE-Behälter auf dem Rollenbock hergestellt.

Das Vorprodukt 2 wird durch Sprühgranulation von Vorprodukt 1 hergestellt. Das Granulat wird bei 450°C an Luft in einem Fused Silica-Tiegel entbindert.

Zur Herstellung von Vorprodukt 3 wird das Granulat in einer Temperaturbehandlung bei 1000°C in einem abgedeckten Tiegel eine Stunde geglüht. 500g Ethanol und 750g des Vorprodukts 3 werden in einem PE-Behälter mit Mahlkugeln gemahlen und homogenisiert zur Herstellung von Vorprodukt 4. Die mittlere Partikelgröße von Vorprodukt 4 liegt bei 6 µm. Das Vorprodukt 4 wird durch einmaliges Fluten auf einem Fused Silica-Tiegel mit einer Schichtdicke von ca. 300 µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig. Die Ergebnisse des Tape-Tests sind für Beispiel 8 in Fig. 1 dargestellt. Der Bindergehalt in der Beschichtung beträgt 24 Gew.-%. Der Sauerstoffgehalt der Beschichtung beträgt 16,1 Gew.-%.

### Beispiel 9:

Das Vorprodukt 1 wird durch Homogenisierung von 3000g Inosil S-B, 1000g Ethanol, 4000g UBE E 10 und 100g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 1000°C unter Stickstoffatmosphäre in einem Tiegel eine Stunde geglüht. 500g Ethanol und 750g des Vorprodukts 3 werden in einem PE-Behälter mit Mahlkugeln gemahlen und homogenisiert zur Herstellung von Vorprodukt 4. Die mittlere Partikelgröße von Vorprodukt 4 liegt bei 5,um. Das Vorprodukt 4 wird durch einmaliges Fluten auf einem Fused Silica-Tiegel mit einer Schichtdicke von ca. 300 µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig. Der Bindergehalt in der Beschichtung beträgt 20 Gew.-%.

### Beispiel 10:

Das Vorprodukt 1 wird durch Homogenisierung von 3000g Inosil S-B, 1000g Ethanol, 4000g UBE E 10 und 100g PVB mit Siliciumnitrid-Mahlkugeln in einem PE-Behälter auf dem Rollenbock hergestellt.

Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 900°C in einem abgedeckten Tiegel eine Stunde geglüht. 470g Ethanol und 750g des Vorprodukts 3 werden in einem PE-Behälter mit Mahlkugeln gemahlen und homogenisiert zur Herstellung von Vorprodukt 4. Die mittlere Partikelgröße von Vorprodukt 4 liegt bei 5,um. Das Vorprodukt 4 wird durch einmaliges Fluten auf einem Fused Silica-Tiegel mit einer Schichtdicke von ca. 450 µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig. Der Bindergehalt in der Beschichtung beträgt 20 Gew.-%.

### Beispiel 11:

Das Vorprodukt 1 wird durch Homogenisierung von 500g Ethanol, 3000g Inosil S-B, 4000g UBE E10 und 300g PVB mit Siliciumnitrid-Mahlkugeln in einem PE-Behälter auf dem Rollenbock hergestellt. Das Vorprodukt 2 wird durch Fällung von Vorprodukt 1 in Wasser hergestellt, wobei das Vorprodukt 1 unter starkem Rühren in 201 destilliertes Wasser eingetropft wird. Die Granulatgröße beträgt ca. 1-3 mm.

Das Granulat wird bei 450°C an Luft in einem Fused Silica-Tiegel entbindert. Zur Herstellung von Vorprodukt 3 wird das Granulat in einer Temperaturbehandlung bei 1000°C in einem abgedeckten Tiegel eine Stunde geglüht. 500g Ethanol und 750g des Vorprodukts 3 werden zur Herstellung von Vorprodukt 4 in einem PE-Behälter mit Mahlkugeln gemahlen und homogenisiert. Die mittlere Partikelgröße von Vorprodukt 4 liegt bei 5µm. Das Vorprodukt 4 wird durch einmaliges Fluten auf einem Fused Silica- Tiegel mit einer Schichtdicke von ca. 300 µm appliziert. Die Schicht wird 24h an Luft getrocknet und anschließend mit einer Aufheiz- und Abkühlzeit von 8 Stunden bei 1125°C eingebrannt.

Die Beschichtung ist defektfrei und nicht pulverig. Der Bindergehalt in der Beschichtung beträgt 20 Gew.-%.

### Beispiel 12:

Das Vorprodukt 1 wird durch Homogenisierung von 1200g Ethanol, 2450g Inosil S-B, 4580g UBE E10 und 200g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 800°C in einem abgedeckten Tiegel eine Stunde geglüht. 500g Ethanol und 750g des Vorprodukts 3 werden zur Herstellung von Vorprodukt 4 in einem PE-Behälter mit Mahlkugeln gemahlen und homogenisiert. Die mittlere Partikelgröße von Vorprodukt 4 liegt bei 2,5 µm. Das Vorprodukt 4 wird durch einmaliges Fluten auf einem Fused Silica-Tiegel mit einer Schichtdicke von ca. 400 µm appliziert. Die Schicht wird 24h an Luft getrocknet und anschließend mit einer Aufheiz- und Abkühlzeit von 8 Stunden bei 1125°C an Luft eine Stunde eingebrannt.

Die Beschichtung ist defektfrei und nicht pulverig.

Die Haftfestigkeit der Beschichtung ist in Tabelle 1 dargestellt, die Ergebnisse des Tape-Tests sind in Fig. 1 gezeigt. Die Dichte der Beschichtung beträgt 1,22 g/cm³. Der Bindergehalt in der Beschichtung beträgt 15 Gew.-%. Der Sauerstoffgehalt der Beschichtung beträgt 13 Gew.-%.

### Beispiel 13:

Das Vorprodukt 1 wird durch Homogenisierung von 1200g Ethanol, 2450g Inosil S-B, 4580g UBE E10 und 200g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 900°C in einem abgedeckten Tiegel eine Stunde geglüht. 500g Ethanol und 750g des Vorprodukts 3 werden zur Herstellung von Vorprodukt 4 in einem PE-Behälter mit Mahlkugeln gemahlen und homogenisiert. Die mittlere Partikelgröße von Vorprodukt 4 liegt bei 5µm. Das Vorprodukt 4 wird per einmaligem Fluten auf einem Fused Silica-Tiegel mit einer Schichtdicke von ca. 350 µm appliziert. Die Schicht wird 24h an Luft getrocknet und anschließend mit einer Aufheiz- und Abkühlzeit von 8 Stunden bei 1125°C im gasbefeuerten Ofen eingebrannt.

Die Beschichtung ist defektfrei und nicht pulverig.

Die Haftfestigkeit der Beschichtung ist in Tabelle 1 dargestellt, die Ergebnisse des Tape-Tests sind in Fig. 1 gezeigt. Der Bindergehalt in der Beschichtung beträgt 15 Gew.-%. Der Sauerstoffgehalt der Beschichtung beträgt 11,3 Gew.-%.

### Beispiel 14:

Das Vorprodukt 1 wird durch Homogenisierung von 1200g Ethanol, 2450g Inosil S-B, 4580g UBE E10 und 200g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 800°C in einem abgedeckten Tiegel eine Stunde geglüht. 470g Ethanol und 750g des Vorprodukts 3 werden zur Herstellung von Vorprodukt 4 in einem PE-Behälter mit Mahlkugeln gemahlen und homogenisiert. Die mittlere Partikelgröße von Vorprodukt 4 liegt bei 2,5 µm. Das Vorprodukt 4 wird durch Fluten auf einem Fused Silica-Tiegel mit einer Schichtdicke von ca. 2000 µm appliziert. Die Schicht wird 24h an Luft getrocknet und anschließend mit einer Aufheiz-und Abkühlzeit von 8 Stunden bei 1125°C an Luft eingebrannt.

Die Beschichtung ist defektfrei und nicht pulverig. Der Bindergehalt in der Beschichtung beträgt 15 Gew.-%. Der Sauerstoffgehalt der Beschichtung beträgt 12,6 Gew.-%.

### Beispiel 15:

Das Vorprodukt 1 wird durch Homogenisierung von 1200g Ethanol, 2450g Inosil S-B, 4580g UBE E10 und 200g PVB mit Siliciumnitrid-Mahlkugeln in einem PE-Behälter auf dem Rollenbock hergestellt. Das Vorprodukt 2 wird durch Sprühgranulation von Vorprodukt 1 hergestellt. Das Granulat wird bei 450°C an Luft in einem Fused Silica-Tiegel entbindert. Zur Herstellung von Vorprodukt 3 wird das Granulat in einer Temperaturbehandlung bei 900°C unter Stickstoffatmosphäre im Drehrohrofen mit einer Verweilzeit von 40 Minuten geglüht. 500g Ethanol und 750g des Vorprodukts 3 werden zur Herstellung von Vorprodukt 4 in einem PE-Behälter mit Mahlkugeln gemahlen und homogenisiert. Die mittlere Partikelgröße von Vorprodukt 4 liegt bei 6µm. Das Vorprodukt 4 wird per einmaligem Fluten auf einem Fused Silica-Tiegel mit einer Schichtdicke von ca. 400 µm appliziert. Die Schicht wird 24h an Luft getrocknet und anschließend mit einer Aufheiz- und Abkühlzeit von 8 Stunden bei 1125°C im gasbefeuerten Ofen eingebrannt.

Die Beschichtung ist defektfrei und nicht pulverig. Der Bindergehalt in der Beschichtung beträgt 15 Gew.-%. Der Sauerstoffgehalt der Beschichtung beträgt 9,1 Gew.-%.

### Detaillierte Beschreibung der Figuren

Fig. 1 zeigt die Ergebnisse des Tape-Tests.

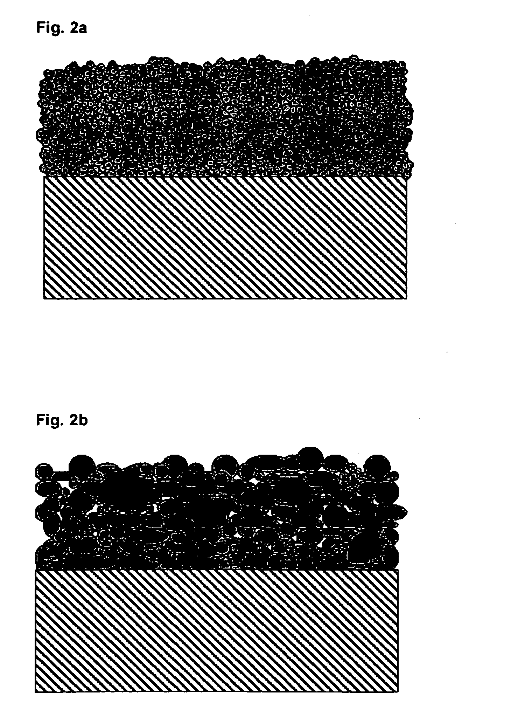

Fig. 2a und 2b zeigen im Vergleich eine schematische Darstellung einer pulvrig aufgetragenen Schicht (Fig. 2b) gemäß Stand der Technik (EP 963 464 B1, WO 2007/039310 A1) und einer erfindungsgemäßen nicht pulvrig aufgetragenen Schicht (Fig. 2a). Die pulvrigen Schichten haben eine niedrige Haftfestigkeit und es kann leicht zu Defekten durch eine mechanische Beanspruchung kommen. Überdies können sich Pulverreste, die sich z.B. beim Beladen von den Tiegelwänden bzw. vom Tiegelboden gelöst haben, im Prozess bei der Konvektion in der Schmelze mitgeschleppt werden und zu Verunreinigungen des Siliciumingots führen. Eine Infiltration der Schicht aufgrund der hohen Porosität und dem Vorhandensein großer Poren kann zu dem gleichen Effekt führen.

Die Beispiele 1 bis 15 führen zu einer Schicht entsprechend der Darstellung in Fig. 2a. Hierbei beträgt die Feinheit der Aggregate entsprechend der Aufmahlung des granulierten Siliciumnitrids in der Beschichtungssuspension 0,2 µm - 30 µm (primär und Aggregatgröße). Die Größe der Poren beträgt typischerweise < 5 µm, vorwiegend < 2 µm.

Schichten entsprechend der Darstellung Fig. 2b entstehen bei den Vergleichsbeispielen 1 bis 3 sowie 4a und 4b, wenn sie pulvrig appliziert werden. Die typische Aggregatgröße in pulvrig gesprühten Beschichtungen ist wie folgt:
1-25 µm (vorwiegend; Primäraggregate, Tropfengröße aus Sprühnebel)
25-50 µm (wenige Primäraggregate dieser Größe)
10-80 µm (Verbunde aus wenigen Aggregaten)
50-400 µm (Verbunde aus vielen Aggregaten)

Typische Größe runder bis flächiger Poren zwischen Primäraggregaten oder Aggregatverbunden: 1-20 µm (vorwiegend)

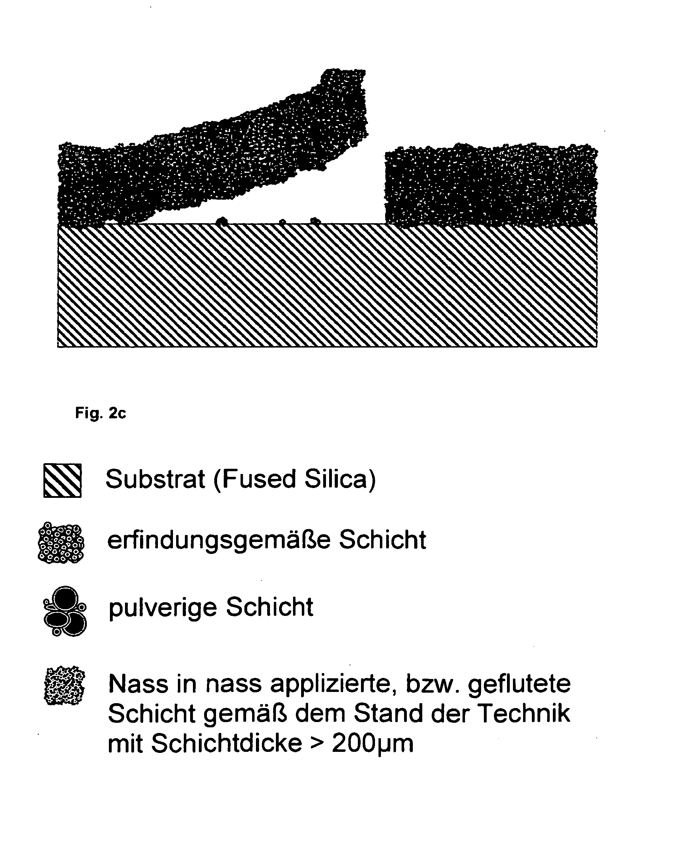

Fig. 2c zeigt eine schematische Darstellung zum "Chipping".

Als Schichtdefekte in Beschichtungen können Risse auftreten (Radialrisse senkrecht zur Oberfläche), die aufgrund von Trocknungsschrumpfung oder von Inhomogenitäten bezüglich Binderkonzentration und Dichte entstehen können. Wenn die Trocknung weiter voranschreitet, beim Einbrennen oder durch weiter voranschreitende Schrumpfung während des Einsatzes der Tiegel können die Risse größer werden und es kann dann auch zum sog. "Chipping" kommen.

Chipping findet dann statt, wenn Spannungen in der Beschichtung zum lokalen Ablösen der Beschichtung vom Substrat führen, z.B. bei zu hoher Schwindung des Binders, größeren Inhomogenitäten in der Dichte der Schicht (was insbesondere beim pulverigen Aufsprühen geschehen kann und zu ungleichmäßiger Schrumpfung führt), Inhomogenitäten in der Binderkonzentration in der Beschichtung (Binderverarmung von Sol-Gel-Bindern, die durch Eindiffundieren in das Substrat entsteht und damit zu hoher Binderkonzentration in der Schichtoberfläche führt und damit zu ungleichmäßiger Schrumpfung), Defekten in der Beschichtung (z.B. vereinzelte große Poren (Luftblasen), Risse z.B. Trocknungsrisse) oder Defekten, die in die Beschichtung eingebracht werden (z.B. beim Beladen eines Siliciumingots oder bei der Umorientierung von gerade aufschmelzendem brockigem Silicium).

Schichten, bei denen es verstärkt zum "Chipping"-Effekt kommt, entstehen bei den Vergleichsbeispielen 4a und 4b, wenn sie über Nass-in-Nass-Sprühen oder Fluten appliziert werden, und ebenso bei Beschichtungen gemäß DE 10 2005 050 593 A1, wenn sie über diese Applikationsmethoden aufgebracht werden und Schichtdicken oberhalb ca. 180 µm aufweisen.

Tabelle 1 zeigt die Versuchsergebnisse des Abzugstests.

**Tabelle 1: Versuchsergebnisse des Abzugstests**

| **Beispiele** | **Glühtemperatur Granulat [°C]** | **Elnbrenntemperatur Beschichtung [°C]** | **Beschichtungsmethode** | **Haftung [N/mm²]** | **Bessere Adhäsion als Kohäsion** |
|---|---|---|---|---|---|
| Vergleichsbeispiel 3 | - | 1000 | pulverig gesprüht | 0,21 | nein, lokal abgelöst |
| Vergleichsbeispiel 4a | - | 500 | pulverig gesprüht | 0,23 | ja |
| Vergleichsbeispiel 4b | - | 750 | pulverig gesprüht | 0,27 | ja |
| Vergleichsbeispiel 3 | - | 1000 | geflutet | nm | nein, plattig abgelöst |
| Vergleichsbeispiel 4a | - | 500 | nass in nass gesprüht | nm | nein, chipping |
| Vergleichsbeispiel 4b | - | 750 | nass in nass gesprüht | nm | nein, chipping |
| Beispiel 3 | 900 | 1125 | nass in nass gesprüht | 1,05 | ja |
| Beispiel 4 | 750 | 1125 | geflutet | 0,49 | ja |
| Beispiel 5 | 800 | 1050 | geflutet | 0,52 | ja |
| Beispiel 6 | 800 | 1100 | geflutet | 0,85 | ja |
| Beispiel 7 | 800 | 1125 | geflutet | 1,29 | ja |
| Beispiel 8 | 1000 | 1125 | geflutet | 0,95 | ja |
| Beispiel 12 | 800 | 1125 | nass in nass gesprüht | 0,48 | ja |
| Beispiel 13 | 900 | 1125 | geflutet | 0,88 | ja |

| | | | | | |
|---|---|---|---|---|---|
| * nicht messbar (s. Erläuterung bei den Beispielen) | | | | | |

## Patentansprüche

1. Schlichte zur Herstellung einer dauerhaften, fest haftenden Trennschicht auf einem Substrat, umfassend eine Suspension von Feststoffteilchen, wobei die Feststoffteilchen 67-95 Gew.-% Siliciumnitrid und 5-33 Gew.-% eines SiO₂-basierten Hochtemperaturbindemittels umfassen, wobei die Herstellung der Schlichte folgende Verfahrensschritte umfasst:
1) Mischen von Vorstufen des SiO₂-basierte Hochtemperaturbindemittels zusammen mit Siliciumnitridpulver und gegebenenfalls Hilfsstoffen zur Erzielung eines Vorprodukts 1,
2) Granulation des Vorprodukts 1 zur Erzielung eines Granulats als Vorprodukt 2,
3) Temperaturbehandlung des Vorprodukts 2 in einem Temperaturbereich von 300-1300°C zur Erzielung eines termperaturbehandelten Granulats als Vorprodukt 3,
4) Aufmahlung des Vorprodukts 3 zur Einstellung der Partikelgröße,
5) Dispergieren des in Schritt 4) erhaltenen Produkts, gegebenenfalls Zusatz von Siliciumnitridpulver, für den Fall, dass dieses im Schritt 1) nicht vollständig eingesetzt wurde, sowie weiterhin gegebenenfalls Zusatz von organischen und anorganischen Bindemitteln zur Herstellung einer Suspension (Schlichte),
und wobei das Siliciumnitrid und das SiO₂-basierte Hochtemperaturbindemittel als Mischgranulat vorliegen.

2. Schlichte nach Anspruch 1, wobei das SiO2-basierte Hochtemperaturbindemittel aus siliciumorganischen SiO₂-Vorstufen aus der Herstellung über einen Sol-Gel-Prozess, vorzugsweise aus einem Nanokomposit aus siliciumorganischen SiO₂-Vorstufen aus der Herstellung über einen Sol-Gel-Prozess, das ebenfalls nanoskalige Feststoffpartikel enthält, abgeleitet ist.

3. Schlichte nach Anspruch 2, wobei die nanoskaligen Feststoffpartikel aus SiO₂, TiO₂, ZrO₂, Al₂O₃, AIOOH, Y₂O₃, CeO₂, Kohlenstoff und/oder BN oder aus Vorstufen dieser nanoskaligen Feststoffteilchen, welche über den Sol-Gel-Prozess in diese Feststoffteilchen umgewandelt werden, ausgewählt sind.

4. Schlichte nach Anspruch 2 und/oder 3, wobei die nanoskaligen Feststoffpartikel SiO₂-Partikel sind.

5. Schlichte nach mindestens einem der Ansprüche 2 bis 4, wobei die nanoskaligen Feststoffpartikel mit einem Oberflächenmodifizierungsmittel modifiziert sind, das eine Anhydridgruppe, Säureamidgruppe, Aminogruppe, SiOH-Gruppe, hydrolysierbare Reste von Silanen und/oder eine β-Dicarbonylgruppe enthält.

6. Schlichte nach Anspruch 1 und/oder 2, wobei das SiO₂-basierte Hochtemperaturbindemittel erhältlich ist nach dem Sol-Gel-Verfahren durch Umsetzung von einem oder mehreren Silanen der allgemeinen Formel (I):
RₓSiA₍₄₋ₓ₎ (I)
worin die Reste A gleich oder verschieden sind und Hydroxylgruppen oder hydrolysierbare Gruppen darstellen, die Reste R gleich oder verschieden sind und nichthydrolysierbare Gruppen darstellen und x den Wert 0, 1, 2 oder 3 hat, wobei bei mindestens 50% der Stoffmenge der Silane x ≥ 1 ist, und Temperaturbehandlung des erhaltenen Umsetzungsprodukts in einem Temperaturbereich von 300-1300°C.

7. Schlichte nach mindestens einem der Ansprüche 2 bis 5, wobei das Nanokomposit erhältlich ist nach dem Sol-Gel-Verfahren durch Umsetzen von nanoskaligen Feststoffpartikeln mit einem oder mehreren Silanen der allgemeinen Formel (I):
RₓSiA₍₄₋ₓ₎ (I)
worin die Reste A gleich oder verschieden sind und Hydroxylgruppen oder hydrolysierbare Gruppen darstellen, die Reste R gleich oder verschieden sind und nichthydrolysierbare Gruppen darstellen und x den Wert 0, 1, 2 oder 3 hat, wobei bei mindestens 50% der Stoffmenge der Silane x ≥ 1 ist.

8. Schlichte nach mindestens einem der vorangehenden Ansprüche, wobei das SiO₂-basierte Hochtemperaturbindemittel durch Temperaturbehandlung im Temperaturbereich von 700-1150°C, vorzugsweise von 800-1050°C, vorbehandelt worden ist.

9. Schlichte nach mindestens einem der vorangehenden Ansprüche, wobei Mischungen von SiO₂-basierten Hochtemperaturbindemitteln, welche bei verschiedenen Temperaturen vorbehandelt worden sind, enthalten sind.

10. Schlichte nach mindestens einem der vorangehenden Ansprüche, wobei die Feststoffteilchen 75-90 Gew.-% Siliciumnitrid und 10-25 Gew.-% des SiO₂-basierten Hochtemperaturbindemittels, vorzugsweise 80-88 Gew.-% Siliciumnitrid und 12-20 Gew.-% des SiO₂-basierten Hochtemperaturbindemittels, umfassen.

11. Formkörper, umfassend ein nichtmetallisches Substrat mit einer dauerhaften, fest haftenden Trennschicht, wobei die Trennschicht 67-95 Gew.-% Siliciumnitrid und 5-33 Gew.-% eines SiO₂-basierten Hochtemperaturbindemittels umfasst und einen Gesamtsauerstoffgehalt von 5-21 Gew.-% aufweist, und erhältlich ist durch ein Verfahren, umfassend die Schritte
a) Vorsehen eines nichtmetallischen Substrats,
b) Auftragen einer Schlichte gemäß mindestens einem der Ansprüche 1-10 auf das Substrat, und
c) Härten der aufgetragenen Schlichte durch Einbrennen bei einer erhöhten Temperatur von 700-1300°C, vorzugsweise 1000-1225°C, weiter vorzugsweise 1050-1200°C, noch weiter vorzugsweise 1075-1175°C, insbesondere bevorzugt 1100-1150°C, zur Ausbildung der dauerhaften fest haftenden Trennschicht.

12. Formkörper nach Anspruch 11, wobei die Trennschicht 75-90 Gew.-% Siliciumnitrid und 10-25 Gew.-% des SiO₂-basierten Hochtemperaturbindemittels, vorzugsweise 80-88 Gew.-% Siliciumnitrid und 12-20 Gew.-% des SiO₂-basierten Hochtemperaturbindemittels, umfasst.

13. Formkörper nach Anspruch 11 und/oder 12, wobei die Trennschicht einen Gesamtsauerstoffgehalt von 6-18 Gew.-%, vorzugsweise 7-15 Gew.-%, aufweist.

14. Formkörper nach mindestens einem der Ansprüche 11-13, wobei die Trennschicht als Mehrfachschicht ausgebildet ist, wobei die vom Substrat abgewandte äußerste Schicht einen Gesamtsauerstoffgehalt von maximal 21 Gew.-%, vorzugsweise maximal 12 Gew.-%, aufweist.

15. Formkörper nach mindestens einem der Ansprüche 11-14, wobei die Trennschicht als Doppelschicht ausgebildet ist, umfassend eine erste, auf das Substrat aufgebrachte Schicht mit einem Gesamtsauerstoffgehalt von maximal 27 Gew.-%, vorzugsweise maximal 16 Gew.-%, sowie eine darüberliegende zweite Schicht mit einem Gesamtsauerstoffgehalt von maximal 21 Gew.-%, vorzugsweise maximal 12 Gew.-%.

16. Formkörper nach mindestens einem der Ansprüche 11-15, wobei das Substrat aus Quarz, Graphit, Keramik oder SiO₂ (fused silica) besteht.

17. Formkörper nach mindestens einem der Ansprüche 11-16, bei dem es sich um einen Schmelztiegel mit einem Substrat aus Quarz, Graphit, Keramik oder SiO₂ (fused silica) für korrosive Nichteisenmetallschmelzen handelt.

18. Formkörper nach mindestens einem der Ansprüche 11-16, bei dem es sich um ein Steigrohr mit einem Substrat aus SiO₂ (fused silica) für die Al-Metallurgie handelt.

19. Formkörper nach mindestens einem der Ansprüche 11-18, wobei die Trennschicht eine Dicke von 80-3000 µm, vorzugsweise 150-2000 µm, weiter vorzugsweise 200-500 µm, aufweist.

20. Verfahren zur Herstellung eines Formkörpers nach mindestens einem der Ansprüche 11-19, umfassend die Schritte
a) Vorsehen eines nichtmetallischen Substrats,
b) Auftragen einer Schlichte gemäß mindestens einem der Ansprüche 1-10 auf das Substrat, und
c) Härten der aufgetragenen Schlichte durch Einbrennen bei einer erhöhten Temperatur von 700-1300°C, vorzugsweise 1000-1225°C, weiter vorzugsweise 1050-1200°C, noch weiter vorzugsweise 1075-1175°C, insbesondere bevorzugt 1100-1150°C, zur Ausbildung der dauerhaften fest haftenden Trennschicht.

21. Verwendung eines Formkörpers gemäß mindestens einem der Ansprüche 11-19 auf dem Gebiet der korrosiven Nichteisenmetallschmelzen.

22. Verwendung eines Schmelztiegels gemäß Anspruch 17 zur Herstellung von Siliciumschmelzen, zur Aufnahme von flüssigem Silicium und/oder zur Kristallisation von flüssigem Silicium zu Siliciumblöcken.

23. Verwendung eines Steigrohrs nach Anspruch 18 in der Al-Metallurgie, insbesondere dem Al-Niederdruckguss.

## Claims

1. Slip for producing a durable, firmly adhering release layer on a substrate, comprising a suspension of solid particles, wherein the solid particles comprise 67-95% by weight of silicon nitride and 5-33% by weight of an SiO₂-based high-temperature binder, wherein the production of the slip comprises the following process steps:
1) mixing of precursors of the SiO₂-based high-temperature binder, together with silicon nitride powder and, if appropriate, auxiliaries to obtain an intermediate 1,
2) granulation of the intermediate 1 to obtain granules as intermediate 2,
3) heat treatment of the intermediate 2 in a temperature range of 300-1300°C to obtain thermally treated granules as intermediate 3,
4) milling of the intermediate 3 to set the particle size,
5) dispersion of the product obtained in step 4), if appropriate addition of silicon nitride powder if this has not all been used in step 1) and also, if appropriate, addition of organic and inorganic binders to produce a suspension (slip),
and wherein the silicon nitride and the SiO₂-based high-temperature binder are present as mixed granules.

2. Slip according to Claim 1, wherein the SiO₂-based high-temperature binder is derived from organosilicon SiO₂ precursors prepared via a sol-gel process, preferably from a nanocomposite comprising organosilicon SiO₂ precursors prepared via a sol-gel process and likewise containing nanosize solid particles.

3. Slip according to Claim 2, wherein the nanosize solid particles are preferably selected from among SiO₂, TiO₂, ZrO₂, Al₂O₃, AlOOH, Y₂O₃, CeO₂, carbon and/or BN or from among precursors of these nanosize solid particles which are converted into these solid particles by means of the sol-gel process.

4. Slip according to Claim 2 and/or 3, wherein the nanosize solid particles are SiO₂ particles.

5. Slip according to at least one of claims 2 to 4, wherein the nanosize solid particles have been modified by a surface-modifying agent which contains an anhydride group, acid amide group, amino group, SiOH group, hydrolysable radicals of silanes and/or a β-dicarbonyl group.

6. Slip according to Claim 1 and/or 2, wherein the SiO₂-based high-temperature binder is obtainable by the sol-gel process by reaction of one or more silanes of the general formula (I):
RₓSiA₍₄₋ₓ₎ (I)
where the radicals A are identical or different and are hydroxyl groups or hydrolysable groups, the radicals R are identical or different and are nonhydrolysable groups and x is 0, 1, 2 or 3, with at least 50 mol% of the silanes having x ≥ 1, and heat treatment of the resulting reaction product in a temperature range of 300-1300°C.

7. Slip according to at least one of Claims 2 to 5, wherein the nanocomposite is obtainable by the sol-gel process by reaction of nanosize solid particles with one or more silanes of the general formula (I):
RₓSiA₍₄₋ₓ₎ (I)
where the radicals A are identical or different and are hydroxyl groups or hydrolysable groups, the radicals R are identical or different and are nonhydrolysable groups and x is 0, 1, 2 or 3, with at least 50 mol% of the silanes having x ≥ 1.

8. Slip according to at least one of the preceding claims, wherein the SiO₂-based high-temperature binder has been pretreated by heat treatment in the temperature range of 700-1150°C, preferably 800-1050°C.

9. Slip according to at least one of the preceding claims, wherein mixtures of SiO₂-based high-temperature binders which have been pretreated at different temperatures are present.

10. Slip according to at least one of the preceding claims, wherein the solid particles comprise 75-90% by weight of silicon nitride and 10-25% by weight of the SiO₂-based high-temperature binder, preferably 80-88% by weight of silicon nitride and 12-20% by weight of the SiO₂-based high-temperature binder.

11. Shaped body which comprises a nonmetallic substrate having a durable, firmly adhering release layer, with the release layer comprising 67-95% by weight of silicon nitride and 5-33% by weight of an SiO₂-based high-temperature binder and having a total oxygen content of 5-21% by weight, and is obtainable by a process comprising the steps
a) provision of a nonmetallic substrate,
b) application of a slip according to at least one of Claims 1-10 to the substrate and
c) hardening of the applied slip by firing at an elevated temperature of 700-1300°C, preferably 1000-1225°C, more preferably 1050-1200°C, even more preferably 1075-1175°C, particularly preferably 1100-1150°C to form the durable, firmly adhering release layer.

12. Shaped body according to Claim 11, wherein the release layer comprises 75-90% by weight of silicon nitride and 10-25% by weight of the SiO₂-based high-temperature binder, preferably 80-88% by weight of silicon nitride and 12-20% by weight of the SiO₂-based high-temperature binder.

13. Shaped body according to Claim 11 and/or 12, wherein the release layer has a total oxygen content of 6-18% by weight, preferably 7-15% by weight.

14. Shaped body according to at least one of Claims 11-13, wherein the release layer is configured as a multiple layer in which the outermost layer facing away from the substrate has a total oxygen content of not more than 21% by weight, preferably not more than 12% by weight.

15. Shaped body according to at least one of Claims 11-14, wherein the release layer is configured as a double layer comprising a first layer which is applied to the substrate and has a total oxygen content of not more than 27% by weight, preferably not more than 16% by weight, and a second layer which is located on top of the first layer and has a total oxygen content of not more than 21% by weight, preferably not more than 12% by weight.

16. Shaped body according to at least one of Claims 11-15, wherein the substrate consists of quartz, graphite, ceramic or SiO₂ (fused silica).

17. Shaped body according to at least one of Claims 11-16 which is a melting crucible having a substrate composed of quartz, graphite, ceramic or SiO₂ (fused silica) for corrosive nonferrous metal melts.

18. Shaped body according to at least one of Claims 11-16 which is a riser tube having a substrate composed of SiO₂ (fused silica) for Al metallurgy.

19. Shaped body according to at least one of Claims 11-18, wherein the release layer has a thickness of 80-3000 µm, preferably 150-2000 µm, more preferably 200-500 µm.

20. Process for producing a shaped body according to at least one of Claims 11-19, which comprises the steps
a) provision of a nonmetallic substrate,
b) application of a slip according to at least one of Claims 1-10 to the substrate and
c) hardening of the applied slip by firing at an elevated temperature of 700-1300°C, preferably 1000-1225°C, more preferably 1050-1200°C, even more preferably 1075-1175°C, particularly preferably 1100-1150°C to form the durable, firmly adhering release layer.

21. Use of a shaped body according to at least one of Claims 11-19 in the field of corrosive nonferrous metal melts.

22. Use of a melting crucible according to Claim 17 for producing silicon melts, for accommodating liquid silicon and/or for crystallizing liquid silicon to form silicon blocks.

23. Use of a riser tube according to Claim 18 in Al metallurgy, in particular low-pressure Al casting.

## Revendications

1. Enduit pour créer une couche de séparation solidement adhérente sur un substrat, comprenant une suspension de particules solides, les particules solides comprenant de 67 à 95 % en poids de nitrure de silicium et de 5 à 33 % en poids d'un agent de liaison à haute température sur base de SiO₂, la fabrication de l'enduit comprenant les étapes de procédé suivantes :
1) Mélange de phases préalables de l'agent de liaison à haute température sur base de SiO₂ avec du nitrure de silicium en poudre et le cas échéant avec des adjuvants pour obtenir un produit semi-fini 1,
2) Granulation du produit semi-fini 1 pour obtenir des granulés en tant que produit semi-fini 2,
3) Traitement thermique du produit semi-fini 2 dans un ordre de température de 300 à 1300 °C pour obtenir des granulés thermotraités en tant que produit semi-fini 3,
4) Broyage du produit semi-fini 3 pour régler la taille des particules,
5) Mise en dispersion du produit obtenu à l'étape 4), le cas échéant ajout de nitrure de silicium en poudre au cas où ce dernier n'aurait pas été totalement mis en oeuvre à l'étape 1), ainsi que par ailleurs, le cas échéant ajout d'agents de liaison organiques et anorganiques pour la fabrication d'une suspension (enduit),
et le nitrure de silicium, ainsi que l'agent de liaison à haute température sur base de SiO₂ se présentant en tant que granulés mélangés.

2. Enduit selon la revendication 1, l'agent de liaison à haute température sur base de SiO₂ étant dérivé de phases préalables organosilicium du SiO₂ issues de la fabrication via un processus sol-gel, de préférence d'un nanocomposite de phases préalables organosilicium du SiO₂ issues de la fabrication via un processus sol-gel qui contient également des particules solides nanométriques.

3. Enduit selon la revendication 2, les particules solides nanométriques étant choisies parmi le SiO₂, le TiO₂, le ZrO₂, l'Al₂O₃, l'AlOOH, le Y₂O₃, le CeO₂, le carbone et/ou le BN ou de phases préalables desdites particules solides nanométriques qui via le processus sol-gel sont transformées en ces particules solides.

4. Enduit selon la revendication 2 et/ou la revendication 3, les particules nanométriques étant des particules de SiO₂.

5. Enduit selon au moins l'une quelconque des revendications 2 à 4, les particules solides nanométriques étant modifiées à l'aide d'un agent modifiant de surface qui contient un groupe anhydride, un groupe d'amides d'acide, un groupe amino, un groupe SiO₂ des radicaux hydrolisables de silanes et/ou un groupe de β-dicarbonyle.

6. Enduit selon la revendication 1 et/ou la revendication 2, l'agent de liaison à haute température sur base de SiO₂ pouvant être obtenu selon le procédé sol-gel par transformation d'un ou de plusieurs silanes de la formule générale (I) :
**RₓSiA₍₄₋ₓ₎** (I)
dans laquelle les radicaux A sont identiques ou différents et désignent des groupes hydroxyles ou des groupes hydrolysables, les radicaux R sont identiques ou différents et désignent des groupes non hydrolysables et x a la valeur 0, 1, 2 ou 3, dans au moins 50 % de la quantité de matière, le silane x étant ≥ 1 et traitement thermique du produit de transformation obtenu dans un ordre de température de 300 à 1300 °C.

7. Enduit selon au moins l'une quelconque des revendications 2 à 5, le nanocomposite pouvant être obtenu selon le procédé sol-gel par transformation de particules solides nanométriques avec un ou plusieurs silanes de la formule générale (I) :
**RₓSiA₍₄₋ₓ₎** (I)
dans laquelle les radicaux A sont identiques ou différents et désignent des groupes hydroxyles ou des groupes hydrolysables, les radicaux R sont identiques ou différents et désignent des groupes non hydrolysables et x a la valeur 0, 1, 2 ou 3, dans au moins 50 % de la quantité de matière, le silane x étant ≥ 1.

8. Enduit selon au moins l'une quelconque des revendications précédentes, l'agent de liaison à haute température sur base de SiO₂ ayant été prétraité par traitement thermique dans un ordre de température de 700 à 1150 °C, de préférence de 800 à 1050 °C.

9. Enduit selon au moins l'une quelconque des revendications précédentes, des mélanges d'agents de liaison à haute température sur base de SiO₂ ayant été prétraités à différentes températures étant contenus.

10. Enduit selon au moins l'une quelconque des revendications précédentes, les particules solides comprenant de 75 à 90 % en poids de nitrure de silicium et de 10 à 25 % en poids de l'agent de liaison à haute température sur base de Si0₂, de préférence de 80 à 88 % en poids de nitrure de silicium et de 12 à 20 % en poids de l'agent de liaison à haute température sur base de SiO₂.

11. Corps moulé comprenant un substrat non métallique avec une couche de séparation durable, solidement adhérente, la couche de séparation comprenant de 67 à 95 % en poids de nitrure de silicium et de 5 à 33 % en poids d'un agent de liaison à haute température sur base de SiO₂, et ayant une teneur totale en oxygène de 5 à 21 % en poids et pouvant être obtenue par un procédé comprenant les étapes
a) prévoir un substrat non métallique,
b) appliquer un enduit selon au moins l'une quelconque des revendications 1 à 10 sur le substrat et
c) faire durcir l'enduit appliqué par cuisson à une température élevée de 700 à 1300 °C, de préférence de 1000 à 1225 °C, de manière très préférentielle de 1050 à 1200 °C de manière encore plus préférentielle de 1075 à 1175 °C, de manière particulièrement préférentielle de 1100 à 1150 °C pour créer la couche de séparation durable solidement adhérente.

12. Corps moulé selon la revendication 11, la couche de séparation comprenant de 75 à 90 % en poids de nitrure de silicium et de 10 à 25 % en poids de l'agent de liaison à haute température sur base de SiO₂, de préférence de 80 à 88 % en poids de nitrure de silicium et de 12 à 20 % en poids de l'agent de liaison à haute température sur base de SiO₂.

13. Corps moulé selon la revendication 11 et/ou la revendication 12, la couche de séparation ayant une teneur totale en oxygène de 6 à 18 % en poids, de préférence de 7 à 15 % en poids.

14. Corps moulé selon au moins l'une quelconque des revendications 11 à 13, la couche de séparation étant conçue en tant que couche multiple, la couche extérieure opposée au substrat ayant une teneur totale en oxygène d'un maximum de 21 % en poids, de préférence d'un maximum de 12 % en poids.

15. Corps moulé selon au moins l'une quelconque des revendications précédentes, la couche de séparation étant conçue en tant que double couche comprenant une première couche appliquée sur le substrat avec une teneur totale en oxygène d'un maximum de 27 % en poids, de préférence d'un maximum de 16 % en poids, ainsi qu'une deuxième couche qui lui est superposée, avec une teneur totale en oxygène d'un maximum de 21 % en poids, de préférence d'un maximum de 12 % en poids.

16. Corps moulé selon au moins l'une quelconque des revendications 11 à 15, le substrat étant en quartz, en graphite, en céramique ou en SiO₂ (fused silica).

17. Corps moulé selon au moins l'une quelconque des revendications 11 à 16, pour lequel il s'agit d'un creuset avec un substrat en quartz, en graphite, en céramique ou en SiO₂ (fused silica) pour des masses fondues de métaux corrosifs non ferreux.

18. Corps moulé selon au moins l'une quelconque des revendications 11 à 16, pour lequel il s'agit d'un tuyau ascendant avec un substrat en SiO₂ (fused silica) pour la métallurgie aluminium.

19. Corps moulé selon au moins l'une quelconque des revendications 11 à 18, la couche de séparation ayant une épaisseur de 80 à 3000 µm, de préférence de 150 à 2000 µm, de manière plus préférentielle de 200 à 500 µm.

20. Procédé de fabrication d'un corps moulé selon au moins l'une quelconque des revendications 11 à 19, comportant les étapes
a) prévoir un substrat non métallique,
b) appliquer un enduit selon au moins l'une quelconque des revendications 1 à 10 sur le substrat et
c) faire durcir l'enduit appliqué par cuisson à une température élevée de 700 à 1300 °C, de préférence de 1000 à 1225 °C, de manière très préférentielle de 1050 à 1200 °C de manière encore plus préférentielle de 1075 à 1175 °C pour créer la couche de séparation durable solidement adhérente.

21. Utilisation d'un corps moulé selon au moins l'une quelconque des revendications 11 à 19 dans le secteur des fonderies de métaux corrosifs non ferreux.

22. Utilisation d'un creuset selon la revendication 17 pour la production de masses fondues de silicium, pour la réception de silicium liquide et/ou pour la cristallisation de silicium liquide en blocs de silicium.

23. Utilisation d'un tuyau ascendant selon la revendication 18 dans la métallurgie aluminium, notamment dans la coulée d'aluminium à basse pression.
